# EUROPEAN PATENT APPLICATION

(11) **EP 4 815 266 A1**
(43) Date of publication of application: **30.09.2026**
(21) Application number: 24893041.4
(22) Date of filing: 27.09.2024
(51) Int. Cl.: H02K 5/04

(54) **MOTOR ASSEMBLY, HYDRAULIC ENERGY SUPPLY DEVICE, CHASSIS SYSTEM, AND VEHICLE**

(30) Priority: 23.11.2023 CN 202323179571 U
(71) Applicant: BYD Company Limited, Shenzhen, Guangdong 518118 (CN)
(72) Inventor: DU, Zhiyong, Shenzhen, Guangdong 518118 (CN); LI, Tianming, Shenzhen, Guangdong 518118 (CN); YU, Fengchuan, Shenzhen, Guangdong 518118 (CN); JIA, Xinglong, Shenzhen, Guangdong 518118 (CN); OU, Xiaoyan, Shenzhen, Guangdong 518118 (CN)
(74) Representative: Mathys & Squire
(86) International application number: PCT/CN2024/121842
(87) International publication number: WO 2025/107882

(57) **Abstract**

The present disclosure provides a motor assembly (700), a hydraulic energy supply device (600), a chassis system, and a vehicle. The motor assembly (700) includes a first motor body (125), a second motor body (225), and a common housing. The second motor body (225) and the first motor body (125) are arranged opposite to each other along the axial direction (D) of the first motor body (125). The second motor body (225) and the first motor body (125) are jointly arranged in the common housing. According to the present disclosure, the first motor body (125) and the second motor body (225) share the common housing, thereby effectively improving the assembly tolerance, improving the sealing performance and the structural strength at the joint between two motors (120 and 220), and also reducing the sealing costs.

## Description

### CROSS-REFERENCE TO RELATED APPLICATIONS

The present disclosure claims priority to Chinese Patent Application No. 202323179571.X filed on November 23, 2023, entitled "MOTOR ASSEMBLY, HYDRAULIC ENERGY SUPPLY DEVICE, CHASSIS SYSTEM, AND VEHICLE", which is incorporated herein by reference in its entirety.

### FIELD

The present disclosure relates generally to the technical field of vehicles, and more particularly to a motor assembly, a hydraulic energy supply device, a chassis system and a vehicle.

### BACKGROUND

A motor pump assembly in related art includes two motor pumps and a motor controller. The motor pump includes a motor and a hydraulic pump. The motor includes a core and a housing. The two housings are independent. The two housings are fixed and sealed by an adhesive. However, this assembly method introduces assembly tolerances between the two housings, and the sealing structure between the two housings is at risk of failure.

### SUMMARY

The summary section introduces a series of simplified concepts, which will be further described in detail in the detailed description section. The summary section of the present disclosure does not mean to attempt to define the key features and essential technical features of the claimed technical solutions, nor does it mean to attempt to determine the protection scope of the claimed technical solutions.

To at least partially solve the above problems, the first aspect of the present disclosure provides a motor assembly. The motor assembly includes a first motor body, a second motor body, and a common housing. The second motor body and the first motor body are arranged opposite to each other along the axial direction of the first motor body. The second motor body and the first motor body are jointly arranged in the common housing.

According to the motor assembly of the first aspect of the present disclosure, the first motor body and the second motor body share the common housing, the assembly tolerance can be effectively improved, the sealing performance and the structural strength at the connection between two motors can be improved, and the sealing costs can be saved.

In an embodiment, the motor assembly includes a first housing and a second housing. The first motor body is arranged in the first housing. The second motor body is arranged in the second housing. The second housing and the first housing are an integral piece to form the common housing.

In an embodiment, the motor assembly includes a first housing and a second housing. An inside of the first housing accommodates the first motor body. An inside of the second housing accommodates the second motor body. The second housing is welded to the first housing to form the common housing.

In an embodiment, an end of the first housing close to the second housing is formed with a recess. An end of the second housing close to the first housing is formed with a boss. The boss is adapted to the recess. The boss is welded and fixed to the recess to fix the second housing to the first housing.

In an embodiment, the motor assembly further includes a motor controller. The motor controller is connected to the common housing. A portion of the common housing facing the motor controller is formed with a first flow channel and a second flow channel. The first flow channel and the first motor body are correspondingly arranged. The second flow channel and the second motor body are correspondingly arranged.

In an embodiment, the common housing includes a housing body, a first flow channel plate, a first flow guide rib, a second flow channel plate and a second flow guide rib. A first mounting groove and a second mounting groove are arranged at a portion of the housing body facing the motor controller. The first flow channel plate is connected to the first mounting groove to form a first heat dissipation cavity with the housing body. The first flow channel plate supports the motor controller. The first flow guide rib is connected to the first heat dissipation cavity to define the first heat dissipation cavity as the first flow channel. The second flow channel plate is connected to the second mounting groove to form a second heat dissipation cavity with the housing body. The second flow channel plate supports the motor controller. The second flow guide rib is connected to the second heat dissipation cavity to define the second heat dissipation cavity as the second flow channel.

In an embodiment, the first flow channel plate includes a first auxiliary heat dissipation body extending to the first flow channel.

In an embodiment, the second flow channel plate includes a second auxiliary heat dissipation body extending to the second flow channel.

In an embodiment, the first auxiliary heat dissipation body is configured to be a first heat dissipation pin. The first flow channel plate includes a plurality of the first heat dissipation pins. Each of the first heat dissipation pins is spaced apart along an arrangement path adapted to the first flow channel.

In an embodiment, the second auxiliary heat dissipation body is configured to be a second heat dissipation pin. The second flow channel plate includes a plurality of the second heat dissipation pins. Each of the second heat dissipation pins is spaced apart along an arrangement path adapted to the second flow channel.

In an embodiment, the first flow guide rib and the housing body are integrally formed.

In an embodiment, the second flow guide rib and the housing body are integrally formed.

In an embodiment, the portion of the common housing facing the motor controller is arranged with an accommodation groove. The accommodation groove is located between the first motor body and the second motor body. The accommodation groove is configured to at least accommodate a capacitor of the motor controller.

In an embodiment, the first flow channel and the second flow channel are spaced apart by the accommodation groove. The first flow channel and the second flow channel are in communication with each other.

In an embodiment, the common housing includes the housing body and a flow-through cover plate. A side wall of the housing body is arranged with a flow-through groove. The flow-through cover plate is sealingly connected to an opening of the flow-through groove to form a flow-through channel with the housing body. The first flow channel and the second flow channel are in communication through the flow-through channel.

In an embodiment, the first flow channel has a first opening and a second opening. The first opening is in communication with the outside of the common housing. The second flow channel has a third opening and a fourth opening. The fourth opening is in communication with the outside of the common housing. The second opening is in communication with the third opening.

In an embodiment, the motor controller further includes a capacitor, a first power device and a second power device. The first power device corresponds to the first motor body. The second power device corresponds to the second motor body. The capacitor is connected to the first power device and the second power device respectively.

In an embodiment, the motor controller includes an electric control housing and a vent valve. The electric control housing is connected to the common housing. The vent valve is connected to the electric control housing. The vent valve is in communication with the inside and outside of the electric control housing.

The second aspect of the present disclosure provides a hydraulic energy supply device for an active suspension. The hydraulic energy supply device includes the motor assembly, a first hydraulic pump and a second hydraulic pump. The first hydraulic pump is connected to a first motor to be driven by the first motor. The second hydraulic pump is connected to a second motor to be driven by the second motor.

According to the hydraulic energy supply device of the second aspect of the present disclosure, by applying the motor assembly, since the first motor and the second motor share the common housing, the assembly efficiency and the assembly precision can be improved, and the sealing performance and the stability of the overall structure are also improved.

The third aspect of the present disclosure provides a chassis system. The chassis system includes a shock absorber and the hydraulic energy supply device. The hydraulic energy supply device is in fluid communication with the shock absorber.

According to the chassis system of the third aspect of the present disclosure, by applying the hydraulic energy supply device, the assembly sealing cost can be saved, the assembly tolerance can be improved, and the overall strength and vibration damping effect of the chassis system can be improved.

The fourth aspect of the present disclosure provides a vehicle. The vehicle includes the motor assembly or the hydraulic energy supply device, or the chassis system.

According to the vehicle of the fourth aspect of the present disclosure, by applying the motor assembly, the hydraulic energy supply device or the chassis system, the service life of the vehicle suspension can be improved, and the stability of the vehicle during driving and the comfort of the driver and passengers are also improved.

In an embodiment, the motor assembly includes the first flow channel and the second flow channel. The first flow channel and the first motor are correspondingly arranged. The first flow channel is configured to circulate a heat exchange medium to cool the first motor and the motor controller. The second flow channel and the second motor are correspondingly arranged. The second flow channel is configured to circulate the heat exchange medium to cool the second motor and the motor controller. The vehicle further includes an air conditioner. The air conditioner is in fluid communication with the first flow channel and/or the second flow channel to share the heat exchange medium with the first flow channel and/or the second flow channel.

### BRIEF DESCRIPTION OF THE DRAWINGS

The following drawings of embodiments of the present disclosure are used herein as a part of the present disclosure for understanding the present disclosure. The drawings illustrate embodiments of the present disclosure and a description thereof, and are used to explain the principles of the present disclosure. In the drawings,
FIG. 1 is a perspective view of a hydraulic energy supply device according to a preferred embodiment of the present disclosure;
FIG. 2 is an exploded perspective view of a first housing in FIG. 1;
FIG. 3 is another exploded perspective view of the first housing in FIG. 1;
FIG. 4 is an exploded perspective view of a second housing in FIG. 1;
FIG. 5 is another exploded perspective view of the second housing in FIG. 1;
FIG. 6 is an exploded perspective view of the first motor pump in FIG. 1;
FIG. 7 is an exploded perspective view of the second motor pump in FIG. 1;
FIG. 8 is a sectional view of the hydraulic energy supply device in FIG. 1;
FIG. 9 is an enlarged view of I in FIG. 8;
FIG. 10 is an exploded perspective view of the hydraulic energy supply device shown in FIG. 1;
FIG. 11 is a perspective view of a hydraulic energy supply device according to another preferred embodiment of the present disclosure;
FIG. 12 is an exploded perspective view of a first housing in FIG. 11;
FIG. 13 is another exploded perspective view of the first housing in FIG. 11;
FIG. 14 is an exploded perspective view of a second housing in FIG. 11;
FIG. 15 is another exploded perspective view of the second housing in FIG. 11;
FIG. 16 is an exploded perspective view of the first motor pump in FIG. 11;
FIG. 17 is an exploded perspective view of the second motor pump in FIG. 11;
FIG. 18 is a sectional view of the hydraulic energy supply device shown in FIG. 11;
FIG. 19 is an exploded perspective view of the hydraulic energy supply device shown in FIG. 11;
FIG. 20 is a perspective view of a hydraulic energy supply device according to still another preferred embodiment of the present disclosure;
FIG. 21 is an exploded perspective view of an integrated housing and flow channel plate in FIG. 20;
FIG. 22 is another exploded perspective view of the integrated housing and flow channel plate in FIG. 20;
FIG. 23 is an exploded perspective view of the hydraulic energy supply device shown in FIG. 20;
FIG. 24 is a sectional view of the hydraulic energy supply device shown in FIG. 20;
FIG. 25 is an exploded perspective view of the hydraulic energy supply device shown in FIG. 20;
FIG. 26 is a perspective view of a connection between a first electrical connecting element and a first motor body according to a preferred embodiment of the present disclosure;
FIG. 27 is a perspective sectional view of the connection between the first electrical connecting element and the first motor body in FIG. 26;
FIG. 28 is a schematic structural view of the first electrical connecting element shown in FIGS. 26 and 27;
FIG. 29 is a perspective view of a connection between a first electrical connecting element and a first motor body according to another preferred embodiment of the present disclosure;
FIG. 30 is a schematic structural view of the first electrical connecting element shown in FIG. 29;
FIG. 31 is an exploded perspective view of the first electrical connecting element shown in FIGS. 29 and 30;
FIG. 32 is a schematic structural view of a conical cylinder shown in FIGS. 29 to 31;
FIG. 33 is a perspective view of a connection between a first electrical connecting element and a first motor body according to still another preferred embodiment of the present disclosure; and
FIG. 34 is a perspective view of the first electrical connecting element shown in FIG. 33.

Explanation of Reference Numerals:
100: first motor pump 110: first hydraulic pump
111: first pump housing positioning post 112: first pump housing sealing ring
113: first connecting hole 114: third connecting hole
120: first motor 121: first housing
121a: first housing body 121b: first mounting groove
121c: first flow guide rib 121d: first electric control housing positioning post
121e: first through hole 121g: first wire passing hole
121h: first resolver through hole 121i: motor housing positioning hole
121j: recess 121n: first pump housing limiting hole
121o: first flow channel 121p: first opening
121q: second opening 121r: first local groove
121s: second through hole 121t: first heat dissipation cavity
122: first heat dissipator
123: first heat pipe 124: first flow channel plate
124a: first auxiliary heat dissipation body 125: first motor body
125a: first core sealing ring 126: first liquid passing connector
127: second liquid passing connector 128: first lead-out wire
129: first insulating sealing element 130: first end cover assembly
131: first end cover 131a: first cantilever
132: first end cover sealing ring 140: detection assembly
141: first sealing ring 142: first temperature sensor
143: second temperature sensor 144: first adapter board
145: adapter post 146: second sealing ring
147: fixing plate 148: second adapter board
149: adapter assembly 150: first resolver assembly
151: first resolver sealing ring 152: first resolver circlip
153: first resolver body 160: first electrical connecting element
161: first electrical connecting terminal 161a: first electrical terminal
161b: second electrical terminal 161c: third electrical terminal
162: protrusion 162a: first clearance portion
162b: first guiding portion 162c: abutting portion
162d: second guiding portion 162e: second clearance portion
163: conical cylinder 163a: connecting hole
163b: first end 163c: second end
163d: groove 164: base
164a: connecting groove 165: base
166: clamping part 166a: positioning groove
167: clamping opening 168: connecting plate
168a: first connecting plate 168b: second connecting plate
168c: third connecting plate 169: second electrical connecting terminal
169a: fourth electrical terminal 169b: fifth electrical terminal
169c: sixth electrical terminal 200: second motor pump
210: second hydraulic pump 211: second pump housing positioning post
212: second pump housing sealing ring 213: third connecting hole
214: fourth connecting hole 220: second motor
221: second housing 221a: second housing body
221b: second mounting groove 221c: second flow guide rib
221d: second electric control housing positioning post 221e: third through hole
221g: second wire passing hole 221h: second resolver through hole
221i: motor housing positioning post 221j: boss
221n: second pump housing limiting hole 221o: second flow channel
221p: third opening 221q: fourth opening
221r: second local groove 221s: fourth through hole
221t: second heat dissipation cavity
222: second heat dissipator 223: second heat pipe
224: second flow channel plate 224a: second auxiliary heat dissipation body
225: second motor body 225a: second core sealing ring
226: third liquid passing connector 227: fourth liquid passing connector
228: second lead-out wire 229: second insulating sealing element
230: second end cover assembly 231: second end cover
231a: second cantilever 232: second end cover sealing ring
250: second resolver assembly 251: second resolver sealing ring
252: second resolver circlip 253: second resolver body
260: second electrical connecting element 300: motor controller
310: electric control housing 320: signal connector
330: busbar electrical terminal 340: vent valve
350: shielding plate 360: control circuit board
370: drive circuit board 371: power device
372: alternating current terminal 373: direct current terminal
375: capacitor 376: first power device
377: second power device 400: accommodation groove
500: housing
500a: accommodation groove 500c: flow-through groove
500e: first mounting groove 500f: first flow guide rib
500g: first through hole 500i: first flow channel
500j: first liquid passing opening 500k: second liquid passing opening
500m: second mounting groove 500n: second flow guide rib
500o: third through hole 500q: second flow channel
500r: third liquid passing opening 500s: fourth liquid passing opening
500t: second through hole 500u: fourth through hole
501: flow-through cover plate 502: flow channel plate
502a: auxiliary heat dissipation body 502b: positioning boss
503: first liquid passing connector 504: second liquid passing connector
600: hydraulic energy supply device
D1: first direction D2: second direction, axial direction
D3: third direction DY1: first extension direction
DY2: second extension direction DY3: third extension direction

### DETAILED DESCRIPTION

In the following description, numerous specific details are set forth to provide a more thorough understanding of the present disclosure. However, it will be apparent to a person skilled in the art that the embodiments of the present disclosure can be practiced without one or more of these specific details. In other instances, well-known features have not been described in order to avoid obscuring the embodiments of the present disclosure.

In order to thoroughly understand the embodiments of the present disclosure, detailed structures will be presented in the following description. It is apparent that the implementation of the embodiments of the present disclosure is not limited to the specific details familiar to a person skilled in the art.

It will be understood that the terminology used herein is for the purpose of describing particular embodiments only and is not intended to be limiting of the present disclosure. The singular forms "a", "an" and "the" are intended to include the plural forms as well, unless the context clearly indicates otherwise. The terms "includes" and/or "including," used in this specification specify the presence of the features, integers, steps, operations, elements, and/or components, but do not preclude the presence or addition of one or more other features, integers, steps, operations, elements, components, and/or combinations thereof.

The ordinal numbers such as "first" and "second" referred to in the present disclosure are merely identifiers and do not have any other meaning, such as a particular order or the like. Also, for example, the term "first component" by itself does not imply the presence of a "second component", and the term "second component" by itself does not imply the presence of a "first component". It will be understood that the terms "upper", "lower", "front", "rear", "left", "right", "inner", "outer" and similar expressions used in the present disclosure are for illustrative purpose only and are not intended to be limiting.

Hereinafter, the specific embodiments of the present disclosure will be described in more detail with reference to the accompanying drawings, which illustrate representative embodiments of the present disclosure and are not intended to limit the present disclosure.

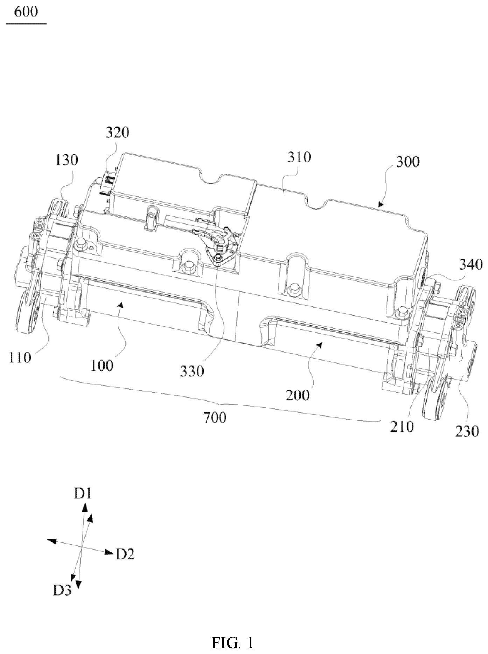

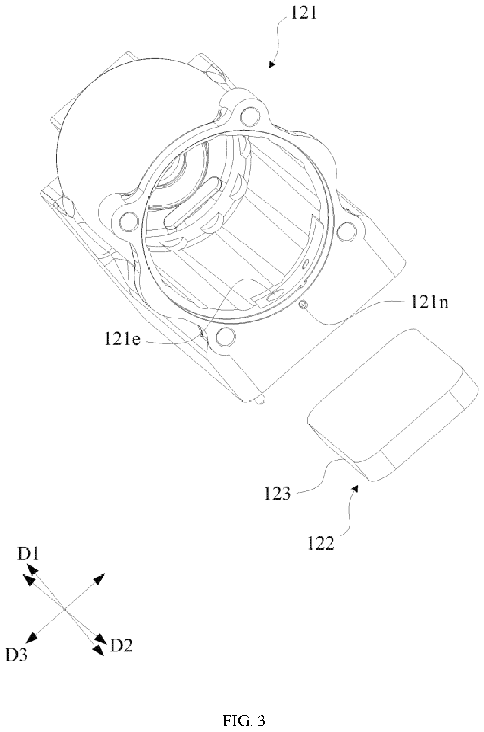

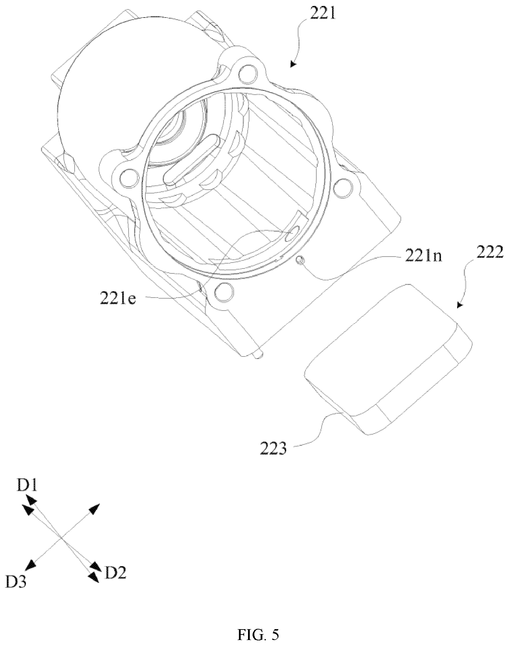

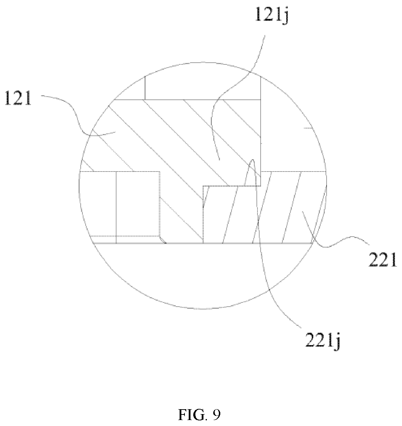

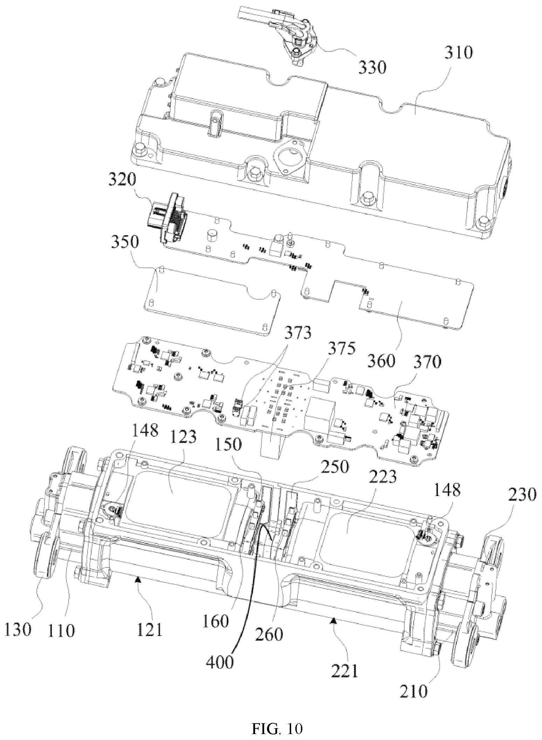

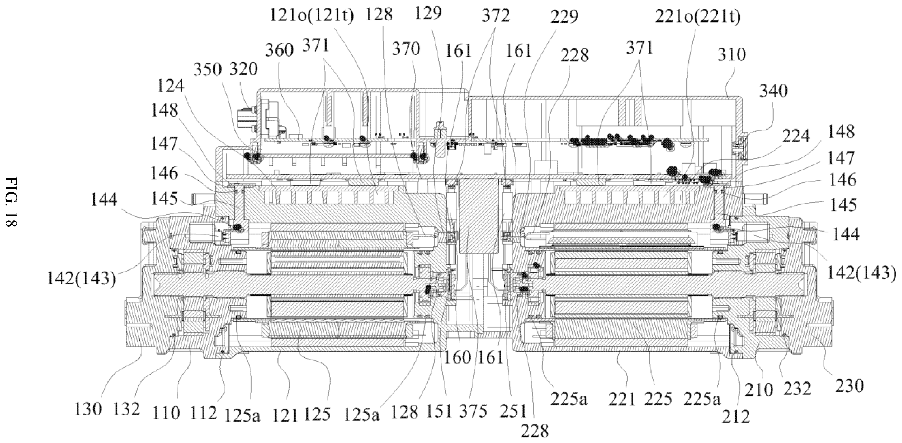

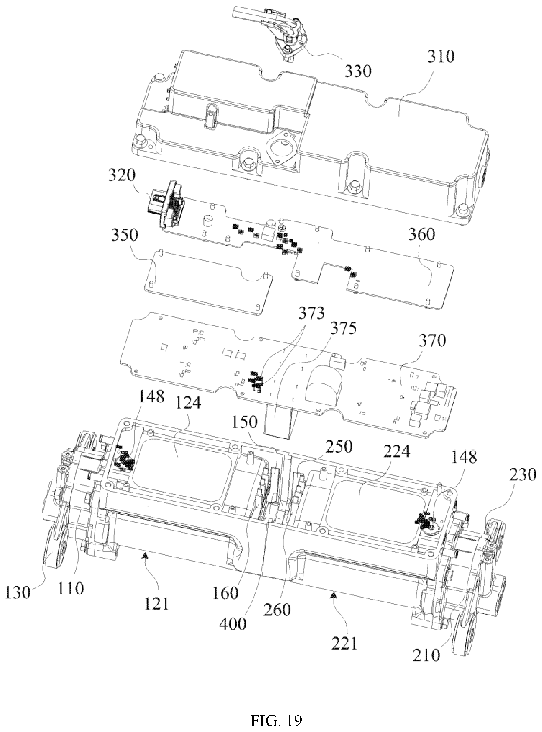

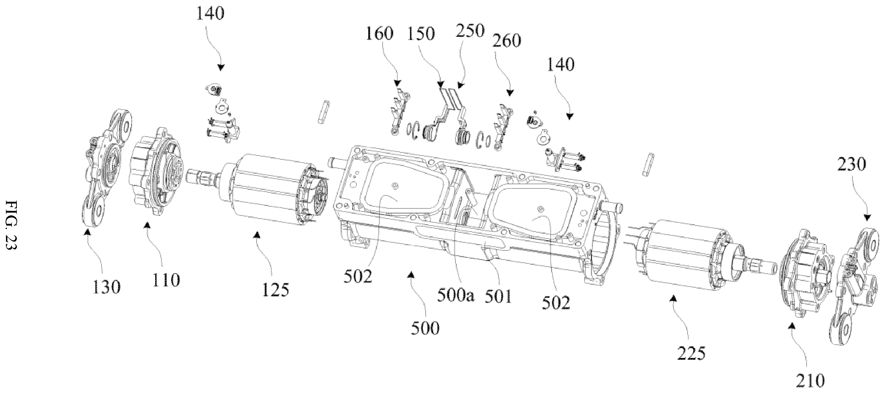

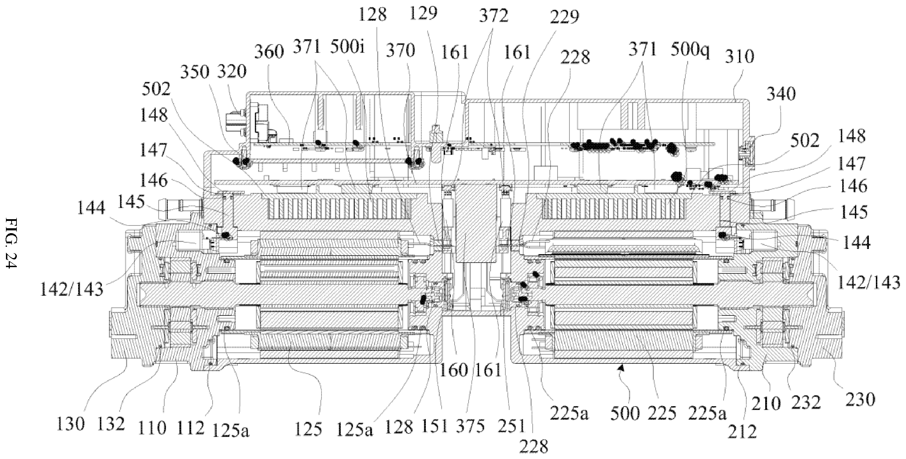

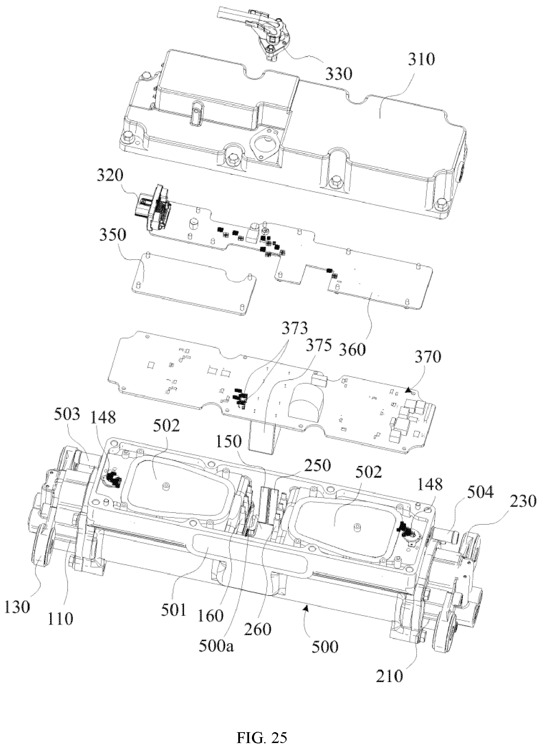

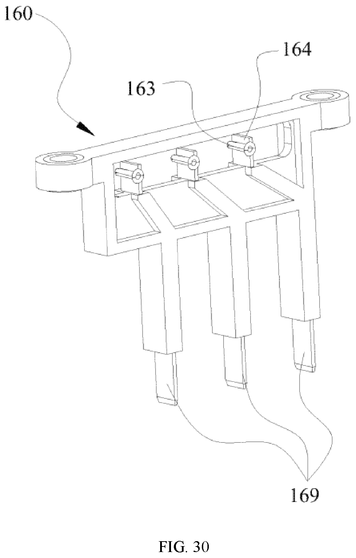

The present disclosure provides a hydraulic energy supply device. The hydraulic energy supply device can be used in an active chassis system. The active chassis system can actively adjust the damping mechanism according to different road conditions, thereby improving the comfort and safety of the vehicle chassis. As shown in FIGS. 1 to 34, the hydraulic energy supply device according to the present disclosure can include a motor pump, a motor controller, and a heat dissipator. The motor pump can include a hydraulic pump and a motor for driving the hydraulic pump. Two motor pumps can constitute a motor pump group. The power of the motor pump group can be greater than 8KW, such as 9KW, etc. The motor and the motor controller can constitute a motor assembly. The motor can include a motor body and a housing. The motor body can include a stator and a rotor. The stator includes a stator winding and a stator core. The stator winding is connected to the stator core. The stator winding includes a winding body and a lead-out wire. The lead-out wire includes a root end and a tip end along the length direction of the lead-out wire, i.e., the two ends of the lead-out wire. The root end of the lead-out wire is connected to the winding body and is fixed on the stator core. For example, the root end of the lead-out wire is wound on the stator core, or one end of the winding connecting the lead-out wire is arranged with a busbar. The lead-out wire is fixedly connected to the busbar. For example, a three-phase motor includes three-phase windings and three lead-out wires corresponding to the three-phase windings. The three-phase windings are all connected to the busbar. The busbar is connected to the three lead-out wires. The three lead-out wires can be an integral structure with the busbar. The tip end of the lead-out wire is connected to an adapter copper bar. The motor pump group includes two motors. The two motors can be respectively referred to as a first motor 120 and a second motor 220. The first motor 120 includes a first winding body and a first lead-out wire 128. The second motor 220 includes a second winding body and a second lead-out wire 228. The motor controller 300 is arranged on the outside of the motor along a first direction D1. In the mounted state of the hydraulic energy supply device to the vehicle, the first direction D1 can be consistent with the height direction of the vehicle, and at this time, the motor controller 300 can be located above the motor. The heat dissipator is located between the motor and the motor controller and is thermally connected to the motor and the motor controller. The heat dissipator is configured to conduct the heat of the motor controller, thereby cooling the motor controller.

According to the hydraulic energy supply device of the present disclosure, by arranging the heat dissipator between the motor and the motor controller 300, the heat of the motor and the motor controller 300 can be conducted, thereby facilitating the heat dissipation of the motor controller 300, and further improving the operation efficiency of the motor controller 300.

Referring to FIGS. 1 to 19, for example, the hydraulic energy supply device according to the present disclosure can include a first motor pump 100, the motor controller 300, and a first heat dissipator 122. The first motor pump 100 can include a first hydraulic pump 110 and a first motor 120 for driving the first hydraulic pump 110. The motor controller 300 is arranged outside the first motor 120 in the first direction D1. In the mounted state of the hydraulic energy supply device to the vehicle, the first direction D1 can coincide with the height direction of the vehicle. At this time, the motor controller 300 can be located above the first motor 120. The motor controller 300 can also be arranged on one side of the motor in the length direction of a vehicle body. For example, when the motor controller 300 is mounted to a front axle of the vehicle, the motor controller 300 can be located on the rear side of the first motor 120. When the motor controller 300 is mounted to a rear axle of the vehicle, the motor controller 300 can be located on the front side of the first motor 120. In this case, the first direction D1 is changed accordingly. In the following description, the present disclosure continues to be described with the first direction D1 as the height direction of the vehicle body, but D1 can also be the length direction. When the direction defined by D1 is changed, the other directions with reference to D1 are adjusted accordingly. The first heat dissipator 122 is located between the first motor 120 and the motor controller 300 and is thermally connected to the first motor 120 and the motor controller 300. The first heat dissipator 122 is configured to conduct heat of the first motor 120 and the motor controller 300. By arranging the first heat dissipator between the first motor and the motor controller 300, heat of the first motor and the motor controller 300 can be conducted, thereby facilitating heat dissipation of the motor controller 300 and improving the operating efficiency of the motor controller 300.

With reference to FIGS. 1 to 19, in addition, the hydraulic energy supply device can further include a second motor pump 200 and a second heat dissipator 222. The second motor pump 200 and the first motor pump 100 are arranged in sequence along a second direction D2. The second direction D2 is parallel to an axis of the first motor 120. Here, the axis of the first motor 120 will be understood as the rotation axis of the rotor of the first motor 120, or will be understood as the axis of the rotor of the first motor 120. That is, the first motor pump 100 and the second motor pump 200 are coaxially and oppositely arranged. Here, the opposite arrangement or the opposite setting will be understood as a sequential arrangement of the first motor 120 and the second motor 220 in opposite orientations. For example, output ends of the first motor 120 and the second motor 220 are respectively oriented toward sides away from each other, or close to each other, instead of a sequential arrangement with the two motors in the same orientation. In the embodiments of the present disclosure, the output ends of the two motors are respectively arranged at two axial ends of the motor assembly. When it is applied in the motor-pump assembly, the two motors are oppositely arranged, facilitating the two motors to share the motor controller 300, and facilitating the output setting of the hydraulic pump. The second motor pump 200 can include a second hydraulic pump 210 and a second motor 220 for driving the second hydraulic pump 210. The first motor 120 is connected to the second motor 220. The motor controller 300 is located outside the second motor 220 along the first direction D1. The second heat dissipator 222 is located between the second motor 220 and the motor controller 300, and is thermally connected to the second motor 220 and the motor controller 300. The second heat dissipator 222 is configured to conduct heat of the second motor 220 and the motor controller 300. In the embodiment, the hydraulic energy supply device includes two motor pumps, and the control of the two motor pumps is realized through the motor controller 300. By arranging the first heat dissipator 122 between the motor controller 300 and the first motor 120, and arranging the second heat dissipator 222 between the motor controller 300 and the second motor 220, the parts of the motor controller 300 corresponding to the first motor 120 and the second motor 220 respectively can be cooled, so that the heat dissipation effect of the motor controller 300 can be improved, and the operation efficiency and the operation stability of the motor controller 300 can be improved.

Optionally, the motor controller can be one or two. When the motor controller is one, the electrical elements and/or devices located in the motor controller can be integrated on a corresponding circuit board, or two sets of integrated circuit boards with the same function can be arranged. When the motor controller is two, one set of integrated circuit boards is arranged for each of the two motor controllers, and the two sets of integrated circuit boards can be the same.

With reference to FIGS. 1 to 10, two heat dissipators are arranged. The two heat dissipators are respectively referred to as the first heat dissipator 122 and the second heat dissipator 222.

With reference to FIGS. 1 to 10, in one example, the first heat dissipator 122 is a first heat pipe 123. The first heat pipe 123 can include a closed shell and a heat conducting medium sealed inside the shell. The heat conducting medium is vaporized by heat so that the first heat pipe 123 can absorb external heat to achieve a cooling effect. The heat conducting medium is liquefied by cold so that the first heat pipe 123 can release heat to the outside to achieve a heat releasing effect. In the embodiment, the first heat pipe 123 can absorb heat of the motor controller 300 and transfer the heat to the first motor 120. Since the first motor 120 is connected to the first hydraulic pump 110, the inside of the first motor 120 also has a part of the hydraulic circuit, so that the heat can be taken away by the hydraulic circuit. The hydraulic circuit can be cooled by other evaporative cooling methods. The first heat pipe 123 can be manufactured and implemented by referring to the mechanism of the heat pipe in the prior art. The first heat pipe 123 can have any shape, such as a square, a circle, a polygon, or any other shape, which can be regular or irregular. Correspondingly, the second heat dissipator 222 can be a second heat pipe 223. The second heat pipe 223 can include a closed shell and a heat conducting medium sealed inside the shell. The heat conducting medium is vaporized by heat so that the second heat pipe 223 can absorb external heat to achieve a cooling effect. The heat conducting medium is liquefied by cold so that the second heat pipe 223 can release heat to the outside to achieve a heat releasing effect. In the embodiment, the second heat pipe 223 can absorb heat of the motor controller 300 and transfer the heat to the second motor 220. Since the second motor 220 is connected to the second hydraulic pump 210, the inside of the second motor 220 also has a part of the hydraulic circuit, so that the heat can be taken away by the hydraulic circuit. The hydraulic circuit can be cooled by other evaporative cooling methods. The second heat pipe 223 can be manufactured and implemented by referring to the mechanism of the heat pipe in the prior art. The second heat pipe 223 can have any shape, such as a square, a circle, a polygon, or any other shape, which can be regular or irregular.

With reference to FIGS. 1 to 10, further, the first motor 120 can include a first housing 121. The first heat pipe 123 is arranged in the first housing 121. Here, a groove can be arranged in the first housing 121, and the first heat pipe 123 can be installed in the groove. This facilitates separate manufacture of the first heat pipe 123 and the first housing 121. Correspondingly, the second motor 220 can include a second housing 221. The second heat pipe 223 is arranged in the second housing 221. Here, a groove can be arranged in the second housing 221, and the second heat pipe 223 can be installed in the groove. This facilitates separate manufacture of the second heat pipe 223 and the second housing 221. The first housing 121 and the second housing 221 are connected to form a common housing. The common housing is a non-detachable housing.

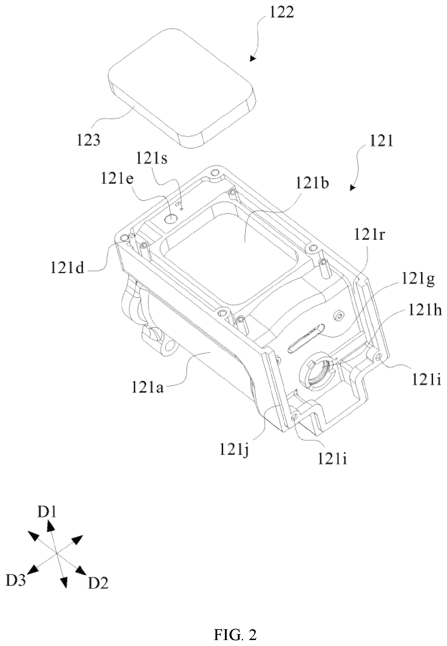

As shown in FIG. 2, FIG. 3, FIG. 6, FIG. 8 and FIG. 10, the first housing 121 has the first heat pipe 123 and the groove for assembling the first heat pipe 123. As the heat pipe has good heat conduction performance, the first heat pipe 123 can better dissipate heat of the power device 371 of the motor controller 300. The power device 371 and the first heat pipe 123 can be connected through a heat conduction medium such as heat conduction silicon grease or a heat conduction structure. The first housing 121 also has a first electric control housing positioning post 121d for limiting position with a positioning hole (not shown) of the electric control housing 310. The first housing 121 also has a motor housing positioning hole 121i for limiting position when assembled with the second housing 221. The first housing 121 also has a first through hole 121e for mounting a temperature sensor. The first housing 121 also has a recess 121j which can be configured for tightly fitting with a boss 221j of the second housing 221 so as to implement friction welding.

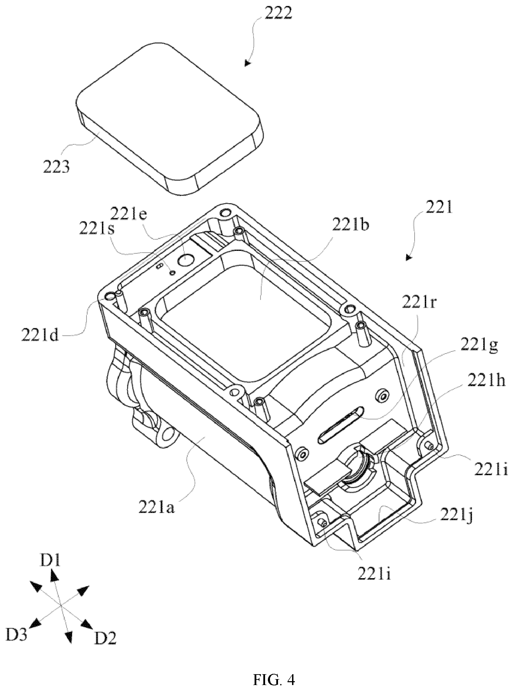

As shown in FIG. 4, FIG. 5, FIG. 7 and FIG. 10, the second housing 221 has the second heat pipe 223 and the groove for assembling the heat pipe. As the heat pipe has good heat conduction performance, the second heat pipe 223 can better dissipate heat of the power device 371 of the motor controller 300. The power device 371 and the second heat pipe 223 can be connected through a heat conduction medium such as heat conduction silicon grease or a heat conduction structure. The second housing 221 also has a second electric control housing positioning post 221d for limiting position with the positioning hole (not shown) of the electric control housing 310. The second housing 221 also has a motor housing positioning hole 121i for limiting position when assembled with the second housing 221. The second housing 221 also has a third through hole 221e for mounting a second temperature sensor. The second housing 221 also has a boss 221j which can be configured for tightly fitting with the recess 121j of the first housing 121 so as to implement friction welding.

Referring to FIG. 1, FIG. 8 and FIG. 10, for example, the motor controller 300 can include an electric control housing 310. The electric control housing 310 is connected to the first housing 121 and the second housing 221. The first heat dissipator 122 is located between the electric control housing 310 and the first housing 121. The second heat dissipator 222 is located between the electric control housing 310 and the second housing 221.

Referring to FIGS. 2 to 10, further, the connection of the first housing 121 and the second housing 221 is formed with an accommodation groove 400. Specifically, the first motor 120 includes a first motor body 125. The first motor body and the second motor body both include the stator and the rotor. The stator includes the stator winding and the stator core. The second motor 220 includes a second motor body 225. The accommodation groove 400 is arranged between the first motor body 125 and the second motor body 225. The accommodation groove 400 is formed in the first housing 121 and the second housing 221. The opening of the accommodation groove 400 faces the motor controller 300. The accommodation groove 400 can be configured to accommodate at least an electrical element or device, such as a capacitor 375, of the motor controller 300. The capacitor 375 can be connected to the power device 371 corresponding to the first heat pipe 123 and the power device 371 corresponding to the second heat pipe 223. In this way, the motor controllers 300 of the two motors are integrated together, the two power devices 371 share one capacitor 375, and the integration degree of the motor controller 300 is improved.

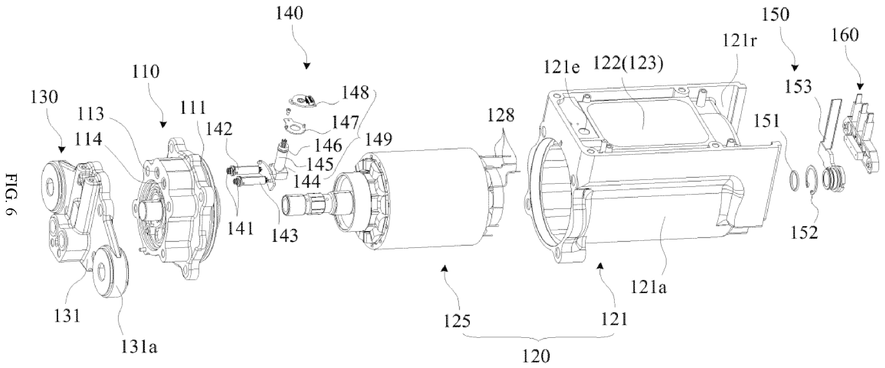

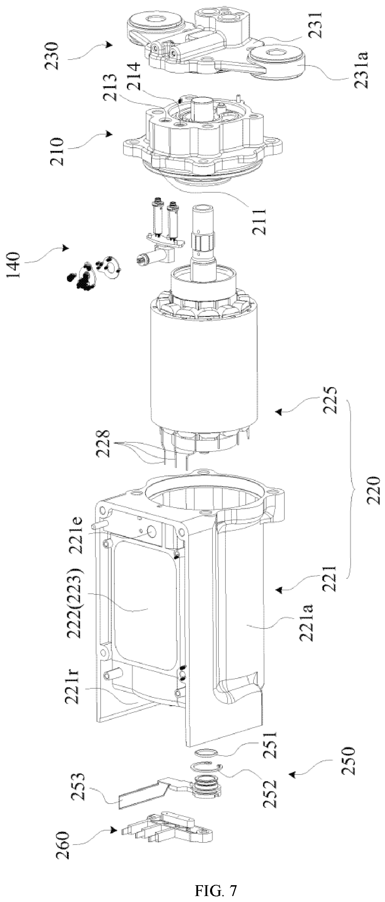

Further, the end of the first housing body 121a of the first housing 121 facing the second housing 221 is recessed to form a first local groove 121r (as shown in FIGS. 2 and 6). The end of the second housing body 221a of the second housing 221 facing the first housing 121 is recessed to form a second local groove 221r (as shown in FIGS. 4 and 7). The first local groove 121r and the second local groove 221r form the accommodation groove 400 after the first housing 121 and the second housing 221 are assembled. The positions of the accommodation groove 400 herein and the accommodation groove 500a hereinafter with respect to the first motor and the second motor, and the functions implemented may be the same.

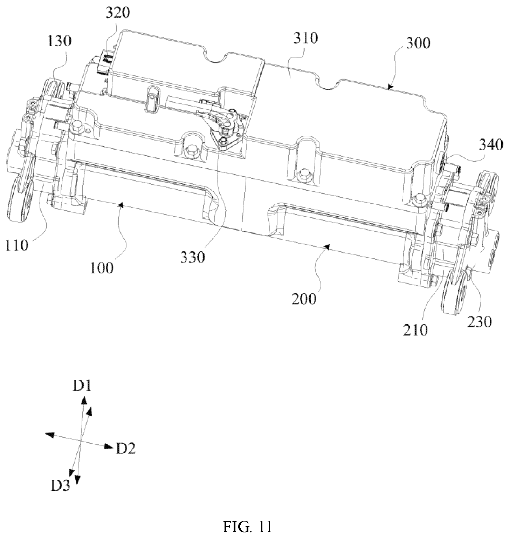

Referring to FIGS. 11 to 19, in another example, the first motor 120 can include the first housing 121. The first heat dissipator 122 is formed in the first housing 121. A first flow channel 121o is formed inside the heat dissipator. The first flow channel 121o is configured to circulate the heat exchange medium. The heat generated by the motor controller 300 can be exchanged through the heat exchange medium, thereby achieving the effect of dissipating and cooling the motor controller 300. The heat exchange medium of the first flow channel 121o can be heat-exchanged at other parts of the heat exchange circuit to achieve cooling of the heat exchange medium. Correspondingly, the second motor 220 can include the second housing 221. The second heat dissipator 222 is formed in the second housing 221. A second flow channel 221o is formed inside the second heat dissipator 222. The second flow channel 221o is configured to circulate the heat exchange medium. The heat generated by the motor controller 300 can be exchanged through the heat exchange medium, thereby achieving the effect of dissipating and cooling. The heat exchange medium of the second flow channel 221o can be heat-exchanged at other parts of the heat exchange circuit to achieve cooling of the heat exchange medium.

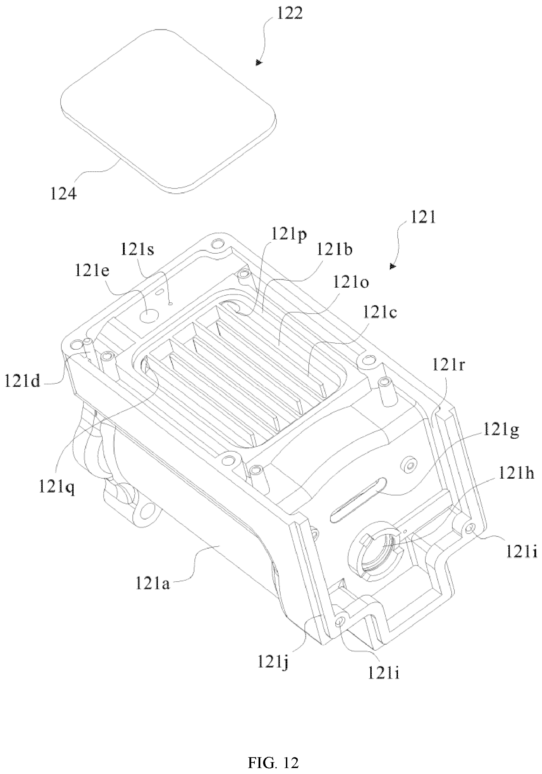

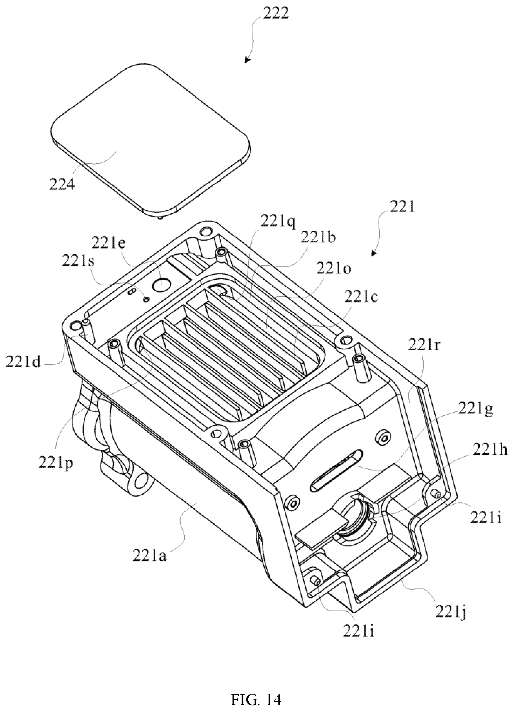

Referring to FIG. 12 and FIG. 14, schematically, the first flow channel 121o is arranged in a meandering configuration. By arranging the first flow channel 121o in a meandering configuration or a circuitous configuration, the residence time of the heat exchange medium in the first flow channel 121o is increased, so that the heat exchange with the motor controller 300 is more sufficient, and a better heat dissipation effect is achieved. Here, the meandering configuration is not limited to the form shown in the figures, and can be any form that can increase the extension length of the first flow channel 121o in the same size area. Correspondingly, the second flow channel 221o is arranged in a meandering configuration. By arranging the second flow channel 221o in a meandering configuration or a circuitous configuration, the residence time of the heat exchange medium in the second flow channel 221o is increased, so that the heat exchange with the motor controller 300 is more sufficient, and a better heat dissipation effect is achieved. Here, the meandering configuration is not limited to the form shown in the figures, and can be any form that can increase the extension length of the second flow channel 221o in the same size area.

Referring to FIGS. 12 to 19, further, the first housing 121 can include the first housing body 121a, a first flow channel plate 124, and a first flow guide rib 121c. The portion of the first housing body 121a facing the motor controller 300 is arranged with a first mounting groove 121b. The first flow channel plate 124 is connected to the first mounting groove 121b to close the opening of the first mounting groove 121b to form a first heat dissipation cavity. That is, the first flow channel plate 124 is covered on the first mounting groove 121b, and the first heat dissipation cavity is formed by enclosing the first flow channel plate 124 and the first housing body 121a. The first heat dissipation cavity can accommodate the heat exchange medium. The first flow channel plate 124 supports the motor controller 300, thereby being capable of absorbing heat from the motor controller 300 and improving heat exchange efficiency. The first flow guide rib 121c is connected to the first heat dissipation cavity to define the first heat dissipation cavity as the first flow channel 121o. The first heat dissipation cavity is divided into the first flow channel 121o by arranged the first flow guide rib 121c in the first heat dissipation cavity. In short, the inner surface of the first mounting groove 121b, the first flow guide rib 121c, and the first flow channel plate 124 are enclosed to form the first flow channel 121o. Accordingly, the second housing 221 can include the second housing body 221a, a second flow channel plate 224, and a second flow guide rib 221c. The portion of the second housing body 221a facing the motor controller 300 is arranged with a second mounting groove 221b. The second flow channel plate 224 is connected to the second mounting groove 221b to close the opening of the second mounting groove 221b to form a second heat dissipation cavity. That is, the second flow channel plate 224 is covered on the second mounting groove 221b, and the second heat dissipation cavity is formed by enclosing the second flow channel plate 224 and the second housing body 221a. The second heat dissipation cavity can accommodate the heat exchange medium. The second flow channel plate 224 supports the motor controller 300, thereby being capable of absorbing heat from the motor controller 300 and improving heat exchange efficiency. The second flow guide rib 221c is connected to the second heat dissipation cavity to define the second heat dissipation cavity as the second flow channel 221o. The second heat dissipation cavity is divided into the second flow channel 221o by arranged the second flow guide rib 221c in the second heat dissipation cavity. In short, the inner surface of the second mounting groove 221b, the second flow guide rib 221c, and the second flow channel plate 224 are enclosed to form the second flow channel 221o.

Further, referring to FIG. 12, FIG. 13, FIG. 16, FIG. 18 and FIG. 19, the first flow channel plate 124 can include a first auxiliary heat dissipation body 124a extending into the first flow channel 121o. By arranging the first auxiliary heat dissipation body 124a on the first flow channel plate 124, the contact area of the first flow channel plate 124 and the heat exchange medium in the first flow channel plate 124 can be increased, thereby further improving the heat exchange efficiency. Correspondingly, referring to FIG. 14, FIG. 15 and FIG. 17 to FIG. 19, the second flow channel plate 224 can include a second auxiliary heat dissipation body 224a extending into the second flow channel 221o. By arranging the second auxiliary heat dissipation body 224a on the second flow channel plate 224, the contact area of the second flow channel plate 224 and the heat exchange medium in the second flow channel plate 224 can be increased, thereby further improving the heat exchange efficiency.

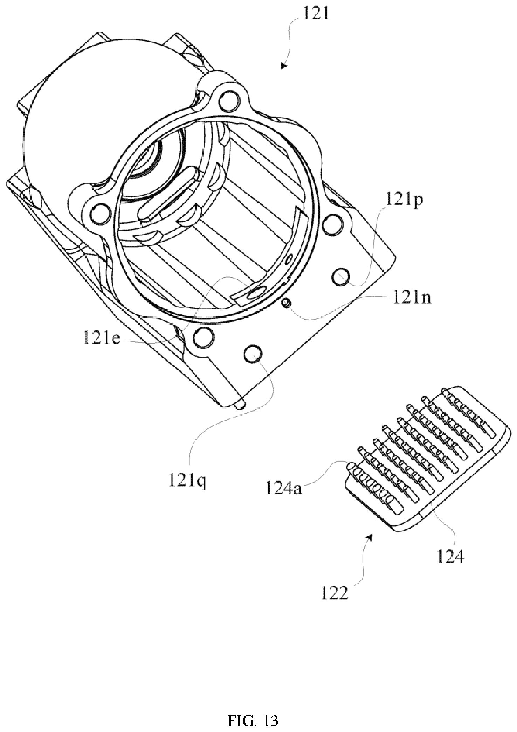

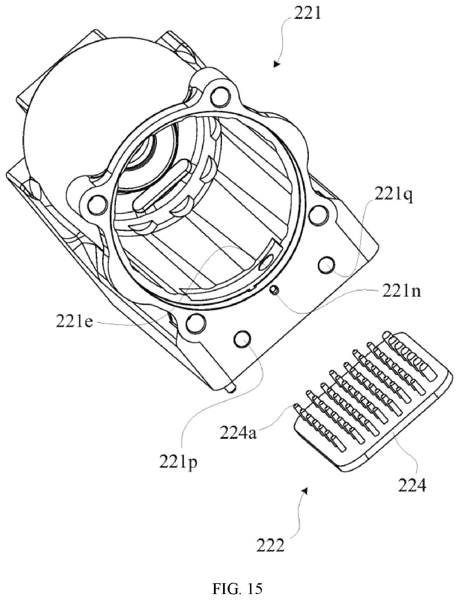

Specifically, as shown in FIG. 13, the first auxiliary heat dissipation body 124a can be configured to be a first heat dissipation pin. The first heat dissipation pin extends along the depth direction of the first mounting groove 121b. The first flow channel plate 124 can include a plurality of first heat dissipation pins. Each of the first heat dissipation pins is spaced apart along an arrangement path adapted to the first flow channel 121o. That is, when the first flow channel plate 124 is covered at the opening of the first mounting groove 121b, the first heat dissipation pin is located in the first flow channel 121o, and the first heat dissipation pin and the first flow guide rib 121c are staggered with each other. Correspondingly, as shown in FIG. 15, the second auxiliary heat dissipation body 224a can be configured to be a second heat dissipation pin. The second heat dissipation pin extends along the depth direction of the second mounting groove 221b. The second flow channel plate 224 can include a plurality of second heat dissipation pins. Each of second heat dissipation pin is spaced apart along an arrangement path adapted to the second flow channel 221o. That is, when the second flow channel plate 224 is covered at the opening of the second mounting groove 221b, the second heat dissipation pin is located in the second flow channel 221o, and the second heat dissipation pin and the second flow guide rib 221c are staggered with each other.

Referring to FIG. 11, FIG. 18 and FIG. 19, for example, the motor controller 300 can include the electric control housing 310. The electric control housing 310 is connected to the first housing 121 and the second housing 221. The first heat dissipator 122 is located between the electric control housing 310 and the first housing 121. The second heat dissipator 222 is located between the electric control housing 310 and the second housing 221.

Referring to FIG. 12, FIG. 14 and FIG. 16 to FIG. 19, further, the connection of the first housing 121 and the second housing 221 is formed with an accommodation groove 400. The accommodation groove 400 can be configured to accommodate at least an electrical element or device, such as the capacitor 375, of the motor controller 300. The capacitor 375 can be connected to the power device 371 corresponding to the first heat pipe 123 and the power device 371 corresponding to the second heat pipe 223. In this way, the motor controllers 300 of the two motors are integrated together, the two power devices 371 share one capacitor 375, and the integration degree of the motor controller 300 is improved.

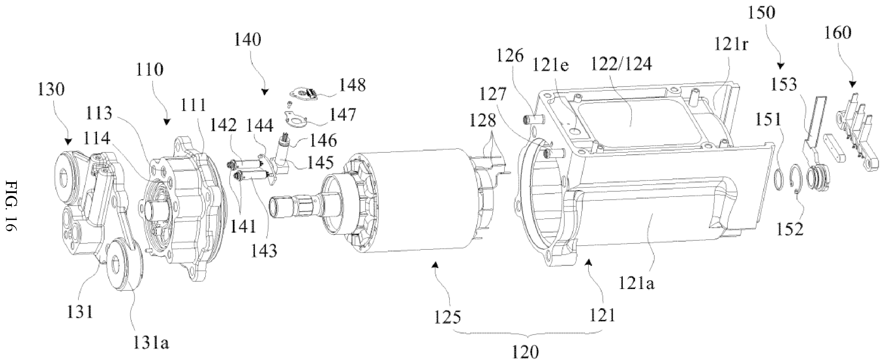

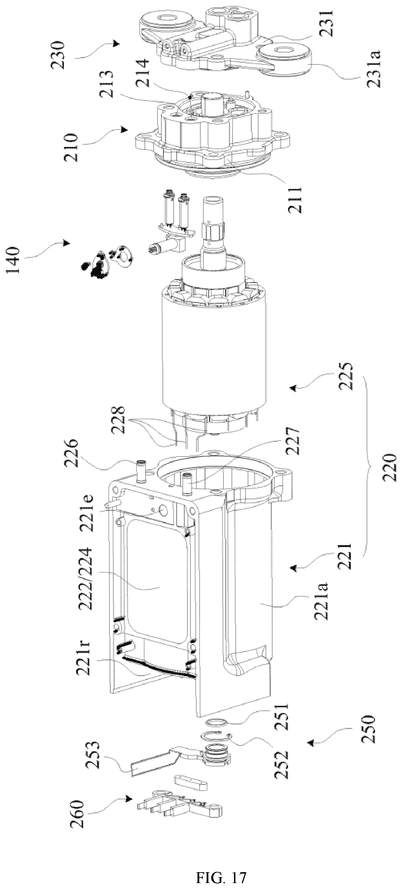

Referring to FIGS. 12 to 19, further, the end of the first housing body 121a of the first housing 121 facing the second housing 221 is recessed to form the first local groove 121r (see FIGS. 12 and 16). The end of the second housing body 221a of the second housing 221 facing the first housing 121 is recessed to form a second local groove 221r (see FIGS. 14 and 17). The first local groove 121r and the second local groove 221r form the accommodation groove 400 after the first housing 121 and the second housing 221 are assembled. The positions of the accommodation groove 400 herein and the accommodation groove 500a hereinafter with respect to the first motor and the second motor, and the functions implemented may be the same.

Referring to FIGS. 11, 18 and 19, optionally, the electric control housing 310 can be fastened to the first housing 121 and the second housing 221 by using fasteners such as bolts. It will be understood that, in order to facilitate the positioning and assembly of the electric control housing 310 with the first housing 121 and the second housing 221 respectively, positioning structures can be arranged at the corresponding positions between the electric control housing 310 and the first housing 121 and between the electric control housing 310 and the second housing 221 respectively. The positioning structure here can be divided into two parts, one part of the positioning structure being arranged on the electric control housing 310 and the other part of the positioning structure being arranged on the first housing 121 and the second housing 221. One part of the positioning structure can be configured to be the positioning hole, and the other part of the positioning structure can be configured to be the positioning post adapted to the positioning hole.

Referring to FIGS. 1 to 19, in one embodiment of the present disclosure, the first housing 121 can be welded to the second housing 221 by using a friction welding process to form the common housing. The common housing here is a non-detachable housing. In the welding process, the first housing 121 and the second housing 221 can be positioned relative to each other by using the motor housing positioning hole 121i on the first housing 121 and the motor housing positioning post 221i on the second housing 221. In this way, the recess 121j of the first housing 121 closely fits with the boss 221j of the second housing 221, so that the connection structure of the first housing 121 and the second housing 221 is firmer after the friction welding.

For example, the end of the first housing 121 along the second direction D2 is formed with the recess 121j (see FIGS. 2 and 6). The end of the second housing 221 along the second direction D2 is formed with the boss 221j (see FIGS. 4 and 7). The boss 221j is adapted to the recess 121j. The boss 221j is welded and fixed to the recess 121j. The cooperation of the recess 121j and the boss 221j facilitates the positioning and assembly between the first housing 121 and the second housing 221. By connecting the first housing 121 and the second housing 221 by welding, the stability of the connection structure between the two can be improved, and the sealing performance at the connection between the first housing 121 and the second housing 221 can be better and more durable by using a reasonable welding process.

It will be understood that if the first housing 121 is connected to the second housing 221 by means of welding , the welding means may not be limited to friction welding, and other welding means that can ensure the stability of the connection structure of the first housing 121 and the second housing 221 and the sealing property of the connection can be selected.

Referring to FIGS. 11 to 19, when the first housing 121 and the second housing 221 are separately manufactured and then assembled into the integrated dual-motor housing, the first flow channel 121o and the second flow channel 221o can be connected in parallel. That is, the first flow channel 121o and the second flow channel 221o are independent of each other in the first housing 121 and the second housing 221. In other words, the first flow channel 121o and the second flow channel 221o are respectively connected to the corresponding devices through pipes outside the hydraulic energy supply device. For example, the first flow channel 121o and the second flow channel 221o are respectively connected to the heat exchange circuit of the air conditioner to share the heat exchange medium with the air conditioner. The parallel connection of the first flow channel 121o and the second flow channel 221o can be applied to the embodiment in which the first housing 121 and the second housing 221 are separately manufactured and then assembled together and share the accommodation groove 400 therebetween. Here, the accommodation groove 400 can affect the arrangement of the first flow channel 121o and the second flow channel 221o.

Specifically, as shown in FIGS. 12 and 13, the first flow passage 121o has a first opening 121p and a second opening 121q. The first opening 121p is for the heat exchange medium to flow into the first flow channel 121o, and the second opening 121q is for the heat exchange medium to flow out of the first flow channel 121o. As shown in FIGS. 14 and 15, the second flow channel 221o has a third opening 221p and a fourth opening 221q. The third opening 221p is for the heat exchange medium to flow into the second flow channel 221o, and the fourth opening 221q is for the heat exchange medium to flow out of the second flow channel 221o. The first opening 121p and the second opening 121q are connected to the heat exchange circuit of the air conditioner through a set of pipes. The third opening 221p and the fourth opening 221q are connected to the heat exchange circuit of the air conditioner through another set of pipes.

Further, as shown in FIGS. 12 and 13, the end of the first housing body 121a for mounting the first hydraulic pump 110 is arranged with the first opening 121p and the second opening 121q. The first opening 121p and the second opening 121q are spaced apart in a third direction D3 perpendicular to the first direction D1 and the second direction D2. The first housing 121 can further include a first liquid passing connector 126 and a second liquid passing connector 127. The first liquid passing connector 126 is mounted to the first opening 121p and communicates with the first heat dissipation cavity and the outside. The second liquid passing connector 127 is mounted to the second opening 121q and communicates with the first heat dissipation cavity and the outside. The first liquid passing connector 126 and the second liquid passing connector 127 are configured to connect pipelines. Correspondingly, as shown in FIGS. 14 and 15, the end of the second housing body 221a for mounting the second hydraulic pump 210 is arranged with the third opening 221p and the fourth opening 221q. The third opening 221p and the fourth opening 221q are spaced apart in the third direction D3 perpendicular to the second direction D2 and the second direction D2. The second housing 221 further includes a third liquid passing connector 226 and a fourth liquid passing connector 227. The third liquid passing connector 226 is mounted to the third opening 221p and communicates with the second heat dissipation cavity and the outside. The fourth liquid passing connector 227 is mounted to the fourth opening 221q and communicates with the second heat dissipation cavity and the outside. The third liquid passing connector 226 and the fourth liquid passing connector 227 are configured to connect pipelines.

In other embodiments not shown, the first flow channel and the second flow channel are respectively located on two sides of the accommodation groove. The first flow channel and the second flow channel are connected in series. For example, a flow-through groove is arranged in the side wall on the same side of the first housing and the second housing. The flow-through groove respectively communicates with the first flow channel and the second flow channel. Specifically, a first flow-through groove is arranged in the side wall of the first housing close to the second housing. A second flow-through groove is arranged in the side wall of the second housing close to the first housing. The first flow-through groove communicates with the second flow-through groove to form the flow-through groove. The hydraulic energy supply device further includes a flow-through cover plate. The flow-through cover plate can be part of the first housing and the second housing. The flow-through cover plate is detachably and sealingly connected to the opening of the flow-through groove to form a flow-through channel. The first flow channel and the second flow channel communicate with each other through the flow-through channel.

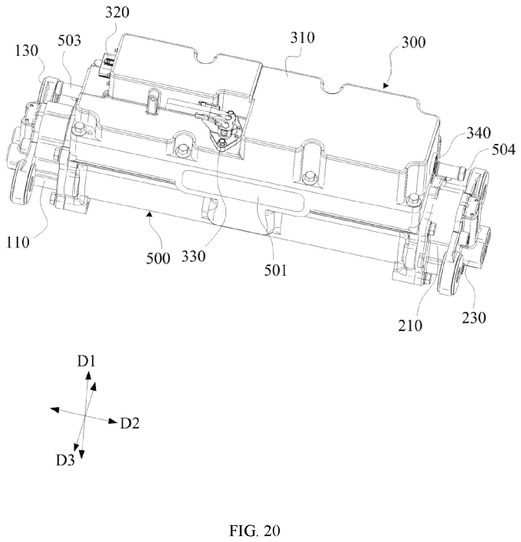

Referring to FIGS. 20 to 25, in another embodiment of the present disclosure, the first housing and the second housing are formed into an integrated double-motor housing, referred to as an integrated housing 500, by the integral molding manufacturing method. The integrated housing 500 is the common housing of the first motor 120 and the second motor 220. The common housing is a non-detachable housing. Compared with the first motor pump 100 and the second motor pump 200 described above, the same parts of the first motor pump and the second motor pump will not be described again, and the differences will be mainly described below.

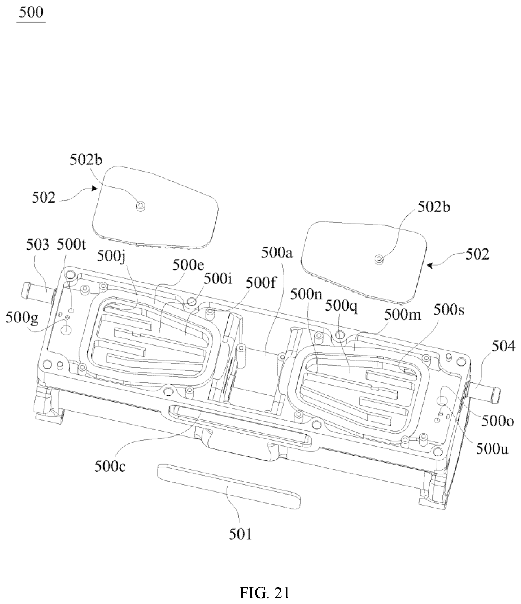

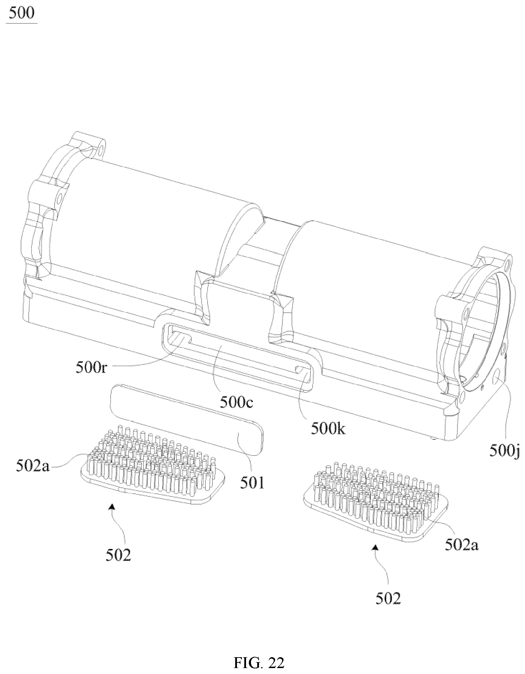

Referring to FIGS. 21 and 22, for example, the integrated housing 500 is arranged with a first liquid passing opening 500j, a second liquid passing opening 500k, a third liquid passing opening 500r, and a fourth liquid passing opening 500s. The first liquid passing opening 500j and the fourth liquid passing opening 500s are arranged at both ends of the integrated housing 500. The second liquid passing opening 500k and the third liquid passing opening 500r are located between the first liquid passing opening 500j and the fourth liquid passing opening 500s. The second liquid passing opening 500k and the first liquid passing opening 500j are spaced apart along the third direction D3 perpendicular to the first direction D1 and the second direction D2. The first liquid passing opening 500j and the second liquid passing opening 500k are both in communication with the first mounting groove 500e. The first mounting groove 500e is arranged with the first flow guide rib 500f. The first mounting groove 500e is mounted with the flow channel plate 502 to form the first flow channel 500i. The fourth liquid passing opening 500s and the third liquid passing opening 500r are spaced apart along the third direction D3. The third liquid passing opening 500r and the fourth liquid passing opening 500s are both in communication with the second mounting groove 500m. The second mounting groove 500m is arranged with the second flow guide rib 500n. The second mounting groove 500m is mounted with the flow channel plate 502 to form the second flow channel 500q. The second liquid passing opening 500k and the third liquid passing opening 500r are located at the same end of the integrated housing 500 along the third direction D3. The surface of the integrated housing 500 facing outward along the third direction D3 is arranged with the flow-through groove 500c. The flow-through groove 500c is arranged close to the second liquid passing opening 500k and the third liquid passing opening 500r along the third direction D3. The flow-through groove 500c is located between the second liquid passing opening 500k and the third liquid passing opening 500r. The flow-through groove 500c extends along the second direction D2 and is in communication with the second liquid passing opening 500k and the third liquid passing opening 500r, respectively. The opening of the flow-through groove 500c faces outward along the third direction D3. The integrated housing 500 can include the flow-through cover plate 501. The flow-through cover plate 501 is covered at the opening of the flow-through groove 500c to close the opening of the flow-through groove 500c. The flow-through cover plate 501, the first housing body 121a, and the second housing body 221a are enclosed to form the flow-through channel. Thus, the first flow channel 500i and the second flow channel 500q formed in the integrated housing are connected in series with each other through the flow-through channel.

Referring to FIGS. 20 to 25, further, the integrated housing 500 can further include the first liquid passing connector 503 and the second liquid passing connector 504. The first liquid passing connector 503 is mounted in the first liquid passing opening 500j and is in communication with the first mounting groove 500e and the outside. The second liquid passing connector 504 is mounted in the fourth liquid passing opening 500s and is in communication with the second mounting groove 500m and the outside. The first liquid passing connector 503 and the second liquid passing connector 504 can be connected to the heat exchange circuit of the air conditioner of the vehicle through the pipe, thereby sharing the heat exchange medium with the air conditioner.

Referring to FIG. 21, FIG. 23 and FIG. 25, optionally, a positioning boss 502b can be arranged on the surface of the flow channel plate 502 facing the motor controller 300. The positioning boss 502b is configured to abut against the drive circuit board 370, thereby positioning the drive circuit board 370 and the flow channel plate 502 along the first direction D1, preventing the drive circuit board 370 from moving along the first direction D1 relative to the flow channel plate 502 due to vibration and the like, and preventing the power device 371 from being damaged due to excessive force.

In some other embodiments not shown, the flow-through groove 500c can also be arranged at other positions of the integrated housing 500. For example, the flow-through groove 500c can be arranged on the side of the integrated housing 500 facing the motor controller 300 along the first direction D1. In this case, the cover plate of the flow-through groove 500c can be integrated with the flow channel plate 502 or can be separately arranged.

Referring to FIG. 21, FIG. 23 and FIG. 25, in addition, the integrated housing 500 is also arranged with a first through hole 500g and a third through hole 500o for mounting the detection assembly 140.

Referring to FIG. 1 to FIG. 34, for example, the first motor 120 can include the first lead-out wire 128. The first lead-out wire 128 is electrically connected to the first winding in the first motor 120, or is a part of the first winding. For example, the first winding can include the first winding body and the first lead-out wire. The first lead-out wire includes the root end and the tip end. Here, the root end and the tip end will be understood as two ends of the first lead-out wire along the length direction of the first lead-out wire. The root end of the first lead-out wire is mounted on the stator core of the first motor 120. The first lead-out wire is the first lead-out wire 128. Alternatively, the tip end of the first lead-out wire is connected to the first lead-out wire. The second motor 220 can include the second lead-out wire 228. The second lead-out wire 228 is electrically connected to the second winding in the second motor 220 or is a part of the second winding. For example, the second winding can include the second winding body and the second lead-out wire. The second lead-out wire includes the root end and the tip end. Here, the root end and the tip end will be understood as two ends of the second lead-out wire along the length direction of the second lead-out wire. The root end of the second lead-out wire is mounted on the stator core of the second motor 220. The second lead-out wire is the second lead-out wire 228. Alternatively, the tip end of the second lead-out wire is connected to the second lead-out wire. The hydraulic energy supply device can further include a first electrical connecting element 160 and a second electrical connecting element 260. The first electrical connecting element 160 and the second electrical connecting element 260 will be understood as adapter copper bars. The adapter copper bars are adapted to be electrically connected to the motor controller 300. In other words, the first electrical connecting element 160 is connected to the first lead-out wire 128 and the motor controller 300. The second electrical connecting element 260 is connected to the second lead-out wire 228 and the motor controller 300. The electrical energy of the power supply is converted by the motor controller 300 and then provided to the first motor 120 and the second motor 220 respectively, thereby controlling the operating states of the first motor 120 and the second motor 220.

It will be understood that the first electrical connecting element 160 can be plugged and mounted with the electrical connection part between the motor controller 300. The first electrical connecting element 160 can be connected to the first lead-out wire 128 by one of the connection means of plugging, welding, and connecting through a fastener.

Referring to FIGS. 2 to 10 and 12 to 19, further, an accommodation groove 400 is formed between the first motor 120 and the second motor 220. The first lead-out wire 128, the second lead-out wire 228, the first electrical connecting element 160, and the second electrical connecting element 260 are at least partially located in the accommodation groove 400. The capacitor 375 and other electrical elements or devices of the motor controller 300 can also be accommodated in the accommodation groove. By arranging the accommodation groove between the first motor 120 and the second motor 220 to accommodate part of the first lead-out wire 128, part of the second lead-out wire 228, the first electrical connecting element 160, the second electrical connecting element 260, and the capacitor 375 and other electrical elements or devices of the motor controller 300, the utilization rate of the axial space of the first motor 120 and the second motor 220 can be improved, the integration degree of the motor controller can be improved, the space occupation in the first direction D1 can be reduced, and the compactness of the structure in the first direction D1 is improved.

Referring to FIGS. 6, 7, 16, and 17, for example, the first motor 120 and the second motor 220 can be three-phase motors. Accordingly, the first motor 120 and the second motor 220 each have three-phase windings. The first lead-out wire 128 includes three-phase first lead-out wires 128. The second lead-out wire 228 includes three-phase second lead-out wires 228. The first electrical connecting element 160 includes a three-phase input part and a three-phase output part. The three-phase input part is connected to the motor controller 300. The three-phase output part is connected to the three-phase windings of the first motor 120. The second electrical connecting element 260 can have the same structure as the first electrical connecting element 160.

Referring to FIGS. 6, 7, 16, and 17, further, the first motor 120 includes three-phase first windings, and three-phase first lead-out wires 128. The first electrical connecting element 160 includes three-phase first electrical connecting terminals 161, and each phase of the first lead-out wires 128 is connected to each phase of the first windings and each phase of the first electrical connecting terminals 161 in one-to-one correspondence. Accordingly, the second motor 220 includes three-phase second windings, and three-phase second lead-out wires 228. The second electrical connector 260 includes three-phase second electrical terminals, and each phase of the second lead-out wires 228 is connected to each phase of the second windings and each phase of the second electrical terminals in one-to-one correspondence.

Further, referring to FIG. 6, FIG. 8, FIG. 10, FIG. 16, FIG. 18 and FIG. 19, the first electrical connecting element 160 can be configured to be the first adapter copper bars. The first electrical connecting terminal 161 and the second electrical connecting terminal 169 can be configured to be structures made of copper. The first electrical connecting terminal 161 and the second electrical connecting terminal 169 of the same phase or electrically connected to the same winding can be configured to be one piece. The second electrical connecting terminal 169 can be connected to the motor controller 300 by the plugging means. Accordingly, referring to FIGS. 7, 8, 10, 17, 18, and 19, the second electrical connecting element 260 can be configured to be the second adapter copper bar. The second electrical terminal and the fifth electrical terminal may be configured to be structures made of copper. The second electrical terminal and the fifth electrical terminal of the same phase or electrically connected to the same winding can be configured to be one piece. The fifth electrical terminal may be connected to the motor controller 300 by the plugging means.

The first motor 120 can include the first winding (not shown). The first winding is at least indirectly abutted, plugged or snapped with the first electrical connecting element 160. It will be understood that, in the case that the first lead-out wire 128 is part of the first lead-out wire of the first winding, the first winding is directly abutted, plugged or snapped with the first electrical connecting element 160. In the case that the first lead-out wire 128 is not part of the first winding but connected to the first lead-out wire of the first winding, the first winding is indirectly abutted, plugged or snapped with the first electrical connecting element 160 through the first lead-out wire 128. The second electrical connecting element 260 is connected to the second motor 220 in the same way.

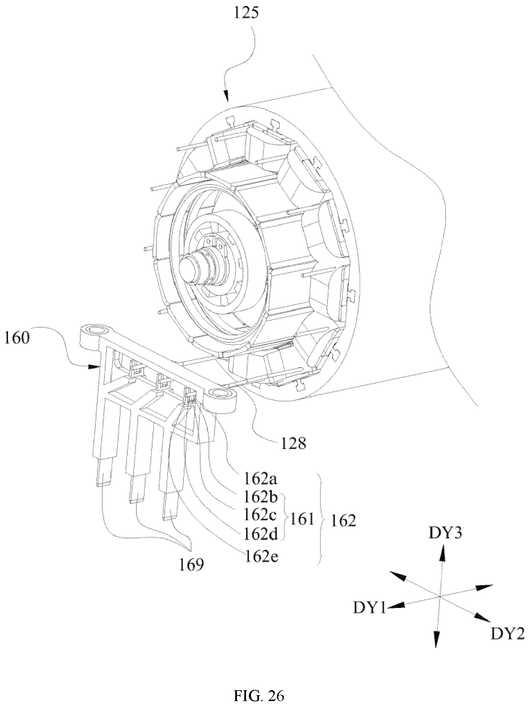

The first electrical connecting element 160 or the second electrical connecting element 260 of the present disclosure is described in detail below with reference to the examples shown in FIG. 26 to FIG. 34.

FIG. 26 to FIG. 28 show an example of the first electrical connecting element 160. The first electrical connecting element 160 and the second electrical connecting element 260 have the same structure. The first electrical connecting element 160 is described here. The first electrical connecting terminal 161 of the first electrical connecting element 160 has a bump. After the first motor body 125 is assembled, the inner conductor of the first lead-out wire 128 is pressed against the bump and electrically connected. Since both sides of the bump are circular arcs, the first lead-out wire 128 can be guided by the circular arc surface when the first lead-out wire 128 is assembled, which is conducive to abutting against a more protruding part of the bump. When the inner conductor of the first lead-out wire 128 abuts against the more protruding part of the bump, the abutting force of the first electrical connecting terminal 161 and the first lead-out wire 128 is greater, so that the first electrical connecting terminal 161 and the first lead-out wire 128 are reliably electrically connected. Since the inner conductor of the first lead-out wire 128 is in contact with the circular arc surface of the bump, the contact area is small, this first electrical connection can be applied to motors with smaller rated current.

Referring to FIGS. 26 to 28, the first electrical connecting terminal 161 according to one embodiment of the present disclosure is configured with a protrusion 162. The protrusion 162 here can be referred to as the bump. One end of the first lead-out wire 128 is electrically connected to the first winding of the first motor 120 or is part of the first winding. The other end of the first lead-out wire 128 extends along a first extension direction DY1 and abuts and electrically connects to the protrusion 162 along a second extension direction DY2. The first extension direction DY1 here can be parallel or nearly parallel to the first direction D1. The first extension direction DY1 being nearly parallel to the first direction D1 will be understood as the angle between the first extension direction DY1 and the first direction D1 being in the range of 0° to 15°. The second extension direction DY2 intersects the first extension direction DY1.

Referring to FIGS. 26 to 28, for example, the first electrical connecting element 160 can include a first electrical connecting terminal 161. The first electrical connecting element 160 is adapted to be electrically connected to the motor controller 300. One end of the first winding is abutted or welded to the first electrical connecting terminal 161. By abutting or welding the first winding to the first electrical connecting terminal 161 of the electrical connecting element, the electrical connection structure between the first winding and the first electrical connecting element 160 can be simplified, the processing cost can be reduced and assembly efficiency can be improved.

Referring to FIGS. 26 to 28, for example, the first motor 120 can include a first stator core. The first winding can include the first winding body (not shown) and the first lead-out wire 128. The first winding body is fixedly connected to the first stator core. The first end of the first lead-out wire 128 is connected to the first winding body. The second end of the first lead-out wire 128 is abutted against the first electrical connecting terminal 161. The first winding body and the first lead-out wire 128 can be an integrated piece, or the first winding body and the first lead-out wire 128 can be two different wires. By abutting the first lead-out wire 128 of the first winding body against the first electrical connecting terminal 161, the connection between the first winding body and the first electrical connecting terminal 161 is achieved, and the connection mode is simpler and the operation more convenient.

Referring to FIGS. 26 to 28, further, the first electrical connecting terminal 161 can include the protrusion 162. The side surface of the first lead-out wire 128 is abutted against the protrusion 162. The first lead-out wire 128 is inclined to the axial direction of the first motor 120. If the first end of the first lead-out wire 128 is fixed relative to the stator or the first housing 121, and the first lead-out wire is parallel or substantially parallel to the axial direction of the first motor 120 in an initial state where the first lead-out wire is not connected to the protrusion 162, by applying a force to the second end of the first lead-out wire 128 to abut the first lead-out wire 128 against the protrusion 162, the first lead-out wire 128 is finally inclined to the axial direction of the first motor 120. At this time, the first lead-out wire 128 is abutted against the protrusion 162 by the elastic force after elastic deformation, so that the connection between the first lead-out wire 128 and the protrusion 162 is more reliable.

Referring to FIGS. 26 to 28, optionally, the first winding body and the first lead-out wire 128 are two different wires. The hardness of the first lead-out wire 128 is greater than the hardness of the first winding body. The first end of the first lead-out wire 128 is at least indirectly fixed to the first stator core. The first electrical connecting terminal 161 includes a protrusion. The first lead-out wire 128 is abutted against the protrusion 162. On a plane perpendicular to the axial direction of the first motor 120, the projection of the protrusion 162 partially overlaps the projection of the first lead-out wire 128. Here, the reliable connection between the first lead-out wire 128 and the protrusion 162 is achieved by abutting the first lead-out wire 128 against the protrusion 162 after elastic deformation of the first lead-out wire 128, which is more convenient and reliable.

It will be understood that the first lead-out wire 128 cannot be a straight wire in a natural state, but can be a curved wire. The curved wire may be such that when one end is fixed, the other end can deform under force and abut against the protrusion, and the purpose of reliable abutment can be achieved, which is also within the scope of the present disclosure.

In other embodiments, when the first lead-out wire overlaps the protrusion 162, there can be no interaction force between the first lead-out wire and the protrusion 162. In this case, the first lead-out wire can be reliably abutted against or connected to the protrusion by means of other structures or process means such as welding.

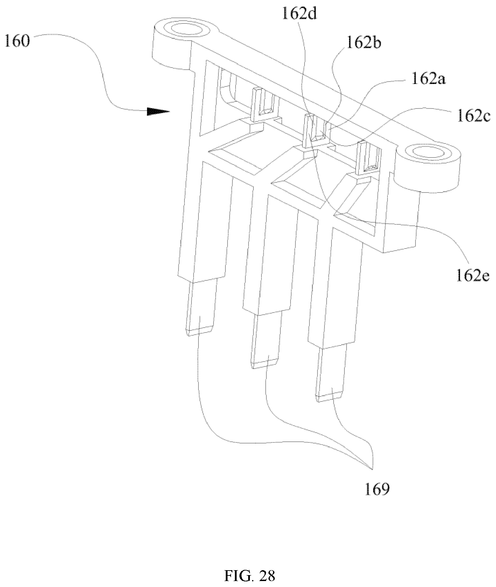

In the example shown in FIGS. 26 and 28, the protrusion is in the shape of a circular arc. The first lead-out wire 128 abuts against the protrusion at the vertex of the protrusion. In this way, the contact area of the first lead-out wire 128 with the protrusion is small, which can be adapted to the application scenario of passing a small current.

For example, the first electrical connecting terminal 161 can include a plate body (not labeled). The protrusion can be formed by a portion of the plate body protruding to one side (as shown in FIGS. 26 to 28), or the protrusion can be formed on one side of the plate body. The manufacturing method can be flexibly selected according to actual needs to achieve the processing and manufacturing of the protrusion.

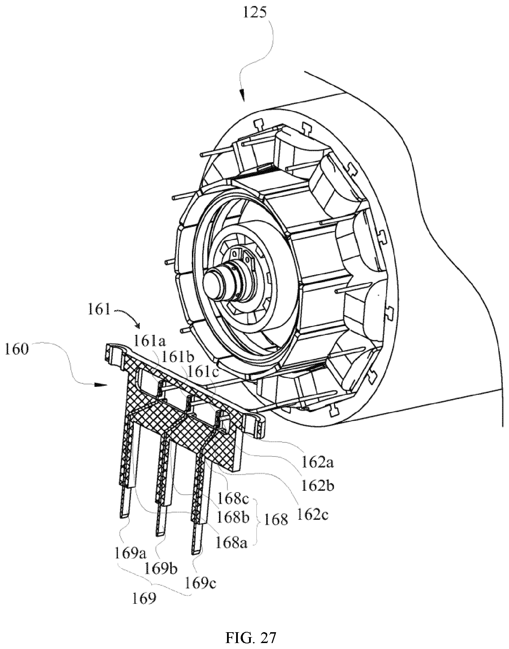

Referring to FIGS. 26 and 27, optionally, the first motor 120 includes three-phase first lead-out wires 128. The first electrical connecting element 160 includes three-phase first electrical connecting terminals 161. Each phase of the first lead-out wires 128 is connected to each phase of the first electrical connecting terminals 161 in one-to-one correspondence. The first electrical connecting element 160 is configured to be the adapter copper bar.

Referring to FIGS. 26 to 28, in addition, the first electrical connecting element 160 can further include a second electrical connecting terminal 169. The second electrical connecting terminal 169 is adapted to be connected to the motor controller 300. Optionally, a connecting plate 168 is further arranged between the second electrical connecting terminal 169 and the first electrical connecting terminal 161. The angle between the connecting plate and the second electrical connecting terminal 169 is greater than 90° and less than 180°. In this way, the spacing between the second electrical connecting terminal and the first electrical connecting terminal can be increased.

Referring to FIGS. 26 to 28, for example, the three sequentially arranged connecting plates 168 are respectively referred to as a first connecting plate 168a, a second connecting plate 168b, and a third connecting plate 168c. The first connecting plate 168a, the second connecting plate 168b, and the third connecting plate 168c are respectively connected to the first electrical connecting terminals 161, which are respectively referred to as a first electrical terminal 161a, a second electrical terminal 161b, and a third electrical terminal 161c. The first connecting plate 168a, the second connecting plate 168b, and the third connecting plate 168c are respectively connected to the second electrical connecting terminals, which are respectively referred to as a fourth electrical terminal 161a, a fifth electrical terminal 161b, and a sixth electrical terminal 161c. The first connecting plate 168a is inclined toward a direction away from the first electrical terminal 161a and the second electrical terminal 161b. The second connecting plate 168b and the third connecting plate 168c are inclined in the same direction as the first connecting plate 168a. An angle between the first connecting plate 168a and the fourth electrical terminal 161a is α1. An angle between the second connecting plate 168b and the fifth electrical terminal 161b is α2. An angle between the third connecting plate 168c and the sixth electrical terminal 161c is α3. α1 < α2 < α3. This arrangement can ensure a safe distance between the three second electrical connecting terminals 169, reduce the distance between the three first electrical connecting terminals 161, and facilitate the arrangement of the three-phase first lead-out wires 128.

Optionally, the first winding includes a first winding body and the first lead-out wire 128. The first end of the first lead-out wire 128 is connected to the first winding body. The first electrical connecting element includes the first electrical connecting terminal. The first electrical connecting terminal includes the protrusion. The first lead-out wire 128 is welded to the protrusion 162. After the protrusion 162 is arranged, welding is performed after the positioning of the first lead-out wire 128 and the first electrical connecting terminal 161 is achieved. This arrangement not only ensures the connection reliability of the lead-out wire with the first electrical connecting terminal 161, but also facilitates the welding process.

Referring to FIGS. 26 and 27, further, the first electrical connecting terminal 161 extends along a third extension direction DY3. The third extension direction DY3 intersects the first extension direction DY1 and the second extension direction DY2.

Referring to FIGS. 26 to 28, for example, in a plane perpendicular to the third extension direction DY3 and intersecting the protrusion 162, the first electrical connecting terminal 161 can include a first clearance portion 162a, a first guiding portion 162b, and an abutting portion 162c connected in sequence along the first extension direction DY1. The first clearance portion 162a is arranged spaced apart from the abutting portion 162c along the first extension direction DY1. The first clearance portion 162a is closer to the first winding along the first extension direction DY1 than the abutting portion 162c. The first clearance portion 162a is arranged spaced apart from the abutting portion 162c along the second extension direction DY2. The protrusion 162 includes the first guiding portion 162b and the abutting portion 162c. In a state where the first electrical connecting element 160 is moved to a position away from the first lead-out wire 128 along the first extension direction DY1, in the plane perpendicular to the first extension direction DY1, the end of the first lead-out wire 128 away from the winding of the first motor 120 is located between the first clearance portion 162a and the abutting portion 162c along the second extension direction DY2, and the end of the first lead-out wire 128 away from the winding of the first motor 120 is arranged spaced apart from the first clearance portion 162a and the abutting portion 162c along the second extension direction DY2, respectively. When the first electrical connecting element 160 approaches the first lead-out wire 128 along the first extension direction DY1 or the first lead-out wire 128 approaches the first electrical connecting element 160 along the first extension direction DY1, the end of the first lead-out wire 128 first abuts against the first guiding portion 162b due to the staggering of the first clearance portion 162a along the second extension direction DY2, and then gradually moves toward the abutting portion 162c under the guidance of the first guiding portion 162b until the end of the first lead-out wire 128 moves to a position completely abutting against the abutting portion 162c. During the movement of the end of the first lead-out wire 128 from the first guiding portion 162b to the abutting portion 162c, the pressing force between the first electrical connecting terminal 161 and the first lead-out wire 128 gradually increases along the second extension direction DY2, thereby ensuring that the first lead-out wire 128 can reliably abut against the abutting portion 162c and preventing poor contact.

It will be understood that the cross-sectional shape of the first guiding portion 162b can be a straight line, a curve, or a combination of a straight line and a curve. In addition, the connection between the first guiding portion 162b and the first clearance portion 162a and the connection between the first guiding portion 162b and the abutting portion 162c can be in a form of smooth transition to ensure that the end of the first lead-out wire 128 can smoothly slide from the first guiding portion 162b to the abutting portion 162c.

Referring to FIGS. 26 to 28, further, in the plane perpendicular to the third extension direction DY3 and intersecting the protrusion 162, the first electrical connecting terminal 161 can further include a second guiding portion 162d and a second clearance portion 162e connected in sequence along the first extension direction DY1. The second guiding portion 162d and the second clearance portion 162e are located on a side of the abutting portion 162c away from the first guiding portion 162b along the first extension direction DY1. The second guiding portion 162d is connected to the abutting portion 162c. The second clearance portion 162e and the first clearance portion 162a are located on the same side of the abutting portion 162c along the second extension direction DY2. The second clearance portion 162e is arranged spaced apart from the abutting portion 162c along the second extension direction DY2. The protrusion 162 further includes the second guiding portion 162d. Thus, in the example in which the first electrical connecting terminal 161 has the second guiding portion 162d and the second clearance portion 162e, the cross-sectional shape of the first electrical connecting terminal 161 is close to an "Ω" shape or a " 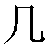 " shape. The "Ω" shape or the " 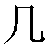 " shape here is only a shape that is close to the cross-sectional shape of the first electrical connecting terminal 161 from the perspective of the overall contour shape, and is not a limitation on the cross-sectional shape of the first electrical connecting terminal 161. By adding the second guiding portion 162d and the second clearance portion 162e, two more bending structures are added to the first electrical connecting terminal 161, which is conducive to improving the structural strength of the first electrical connecting terminal 161, so that the first electrical connecting terminal 161 is less likely to deform and fail when abutted by the first lead-out wire 128 along the second extension direction DY2.

It will be understood that the cross-sectional shape of the second guiding portion 162d here can be a straight line, a curve, or a combination of a straight line and a curve. In addition, the connection between the second guiding portion 162d and the second clearance portion 162e, and the connection between the second guiding portion 162d and the abutting portion 162c can be in the form of a smooth transition. The second guiding portion 162d and the second clearance portion 162e here cannot be in contact with the lead-out wire, and the second guiding portion 162d cannot guide the movement of the first lead-out wire 128 during assembly. Of course, in some cases, if the first electrical connecting terminal 161 can be fitted with lead-out wires in two opposite directions along the first extension direction DY1, such as when sharing one electrical connecting terminal with the lead-out wires of two motors, the second guiding portion 162d has the same function as the first guiding portion 162b, and the second clearance portion 162e has the same function as the first clearance portion 162a.

In other embodiments, the second guiding portion 162d and the second clearance portion 162e cannot be arranged. Alternatively, the abutting portion 162c can extend along the first extension direction DY1 away from the first clearance portion 162a. This helps to increase the conductive contact area of the abutting portion 162c and the first lead-out wire 128.

Optionally, the first lead-out wire 128 is arranged spaced apart from the first clearance portion 162a along the second extension direction DY2. In the case where the first lead-out wire 128 is connected to the first electrical connecting terminal 161, the first lead-out wire 128 is arranged spaced apart from the first clearance portion 162a, to ensure the abutting force of the first lead-out wire 128 and the abutting portion 162c along the second direction D2 is larger.

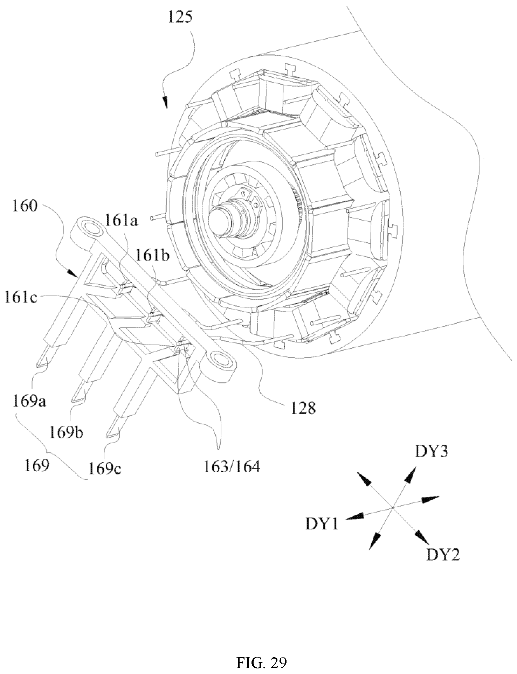

FIGS. 29 to 32 show another example of the first electrical connecting element 160 or the second electrical connecting element 260. The first electrical connecting element 160 and the second electrical connecting element 260 have the same structure. The first electrical connecting element 160 is described as an example. The first electrical connecting terminal 161 of the first electrical connecting element 160 includes a circular arc structure for assembling the conical cylinder 163. The center of the circular arc structure can be collinear with the end of the inner conductor of the first lead-out wire 128. In order to facilitate the first lead-out wire 128 to be assembled into the conical cylinder 163, the end of the conical cylinder 163 facing the first motor 120 is configured to be a guide port. The guide port has a trumpet shape, i.e. the inner diameter of the guide port gradually decreases along the direction away from the first motor 120. The maximum inner diameter of the guide port is larger than the outer diameter of the conductor of the first lead-out wire 128. In order to ensure that the first lead-out wire 128 and the conical cylinder 163 can be in good contact after being assembled, the inner diameter of the end of the conical cylinder 163 away from the guide port is smaller than the outer diameter of the conductor of the first lead-out wire 128. Meanwhile, the end of the conical cylinder 163 away from the guide port is arranged with an opening structure. When the first lead-out wire 128 is assembled into the end of the conical cylinder 163 with a smaller inner diameter, the opening structure will be expanded due to a radial extrusion force. In this way, the first lead-out wire 128 can be conveniently passed through the conical cylinder 163, the contact area of the first lead-out wire 128 and the conical cylinder 163 is increased, and the stability of the connection structure of the conical cylinder 163 and the first lead-out wire 128 is also increased. That is, the first lead-out wire 128 is surrounded by the circumference of the conical cylinder 163 after being assembled into the conical cylinder 163, which achieves good positioning and a large contact area, and is conducive to being applied to a motor needing to transmit a large current.

Referring to FIGS. 29 to 32, the first electrical connecting terminal 161 according to the present disclosure can include a connecting hole 163a extending along the first extension direction DY1, and the connecting hole 163a has a first end 163b and a second end 163c facing opposite along the first extension direction DY1. The first end 163b is closer to the first cavity, i.e. the first winding, than the second end 163c along the first extension direction DY1. The hole diameter of the second end 163c is less than or equal to the outer diameter of the conductor of the first lead-out wire 128. This ensures that the conductor of the first lead-out wire 128 can be in conductive contact with the first electrical connecting terminal 161 when passing through the connecting hole 163a. The hole diameter of the first end 163b is greater than the outer diameter of the conductor of the first lead-out wire 128. This facilitates the conductor of the first lead-out wire 128 to enter the connecting hole 163a from the first end 163b. The first end 163b can guide the insertion of the conductor of the first lead-out wire 128, which can also be referred to as a guide opening. The conductor of the first lead-out wire 128 passes through the connecting hole 163a and is conductively connected to the first electrical connecting terminal 161.

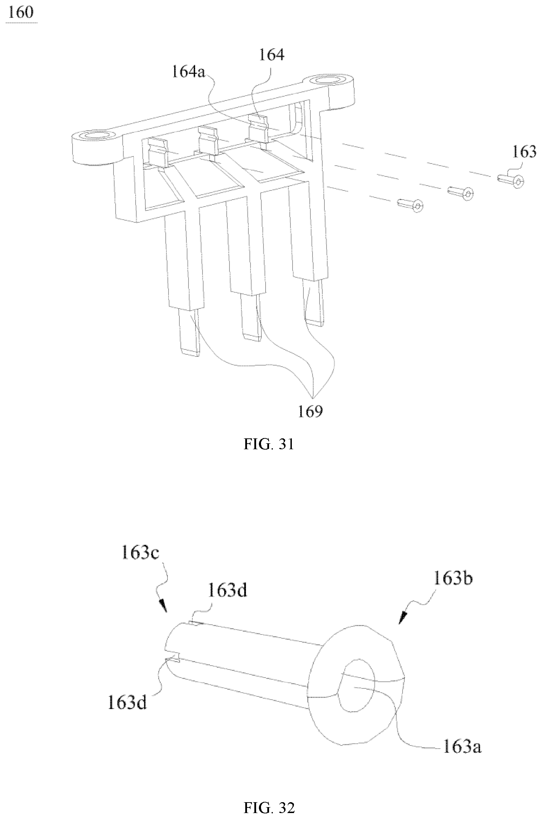

Referring to FIG. 32, for example, the hole diameter of the second end 163c is less than the outer diameter of the conductor of the first lead-out wire 128. The first electrical connecting terminal 161 can include a connecting cylinder extending along the first extension direction DY1. The connecting hole 163a passes through the connecting cylinder along the first extension direction DY1. A portion of the connecting cylinder corresponding to the second end 163c is arranged with a groove 163d. The groove 163d can also be referred to as an opening structure or a fracture opening or a fracture mark. The groove 163d extends along the axial direction of the connecting cylinder or the depth direction of the connecting hole 163a to the end of the second end 163c of the connecting cylinder. The groove 163d is in communication with the connecting hole 163a and the outside along the radial direction. The groove 163d passes through the connecting cylinder along the first extension direction DY1 to the end of the connecting cylinder away from the first end 163b. The groove 163d is configured to be self-adaptively opened when the conductor of the first lead-out wire 128 passes through the second end 163c and is subjected to a pressing force along the radial direction of the connecting cylinder. It will be understood that in the process of the groove 163d being forced to open, the portion of the connecting cylinder between adjacent grooves 163d expands and deforms outwardly along the radial direction, and applies a pressing pre-tightening force to the conductor of the first lead-out wire 128.

Referring to FIG. 32, further, the connecting cylinder is arranged with at least two grooves 163d. Each groove 163d is spaced apart along the circumferential direction of the connecting cylinder. By providing a plurality of grooves 163d, the balance of force distribution between the connecting cylinder and the first lead-out wire 128 can be improved.

Referring to FIGS. 29 and 32, optionally, the at least two grooves 163d are arranged at equal intervals along the circumferential direction of the connecting cylinder.

In the example shown in FIG. 32, the connecting cylinder is arranged with three grooves 163d.

Optionally, the connecting cylinder can be configured to be a metal cylinder capable of elastic deformation. This can increase the radial force between the connecting cylinder and the first lead-out wire 128, make the two more reliably connected, and prevent conductive failure and prolong the service life.

Preferably, the first electrical connecting terminal 161 is configured to be made of copper.

Referring to FIGS. 29 to 32, the first electrical connecting element 160 can further include a base 164. The base 164 is configured with a connecting groove 164a. The connecting groove 164a is adapted to accommodate portion of the connecting cylinder. The connecting cylinder is fixedly connected to the base 164. The base 164 serves to support and fix the connecting cylinder. The connecting cylinder can be separately manufactured from the base 164 and then assembled together. The connecting groove 164a is arranged on the base 164 to facilitate positioning of the connection of the connecting cylinder on the base 164.

For example, the shape of the connecting groove 164a can match the outer shape of the connecting cylinder.

Optionally, the base 164 and the connecting cylinder can be made of copper.

Optionally, the connecting cylinder can be fixed to the base 164 by welding.

Referring to FIGS. 29 to 32 in combination with FIG. 27, the first electrical connecting element 160 can further include the second electrical connecting terminal 169. The second electrical connecting terminal 169 is adapted to be connected to the motor controller 300. Optionally, the connecting plate 168 is arranged between the second electrical connecting terminal 169 and the first electrical connecting terminal 161. The angle between the connecting plate 168 and the second electrical connecting terminal 169 is greater than 90° and less than 180°. This can increase the distance between the second electrical connecting terminal and the first electrical connecting terminal.

Referring to FIGS. 29 to 32 in combination with FIG. 27, for example, the three sequentially arranged connecting plates 168 are respectively referred to as the first connecting plate 168a, the second connecting plate 168b and the third connecting plate 168c. The first connecting plate 168a, the second connecting plate 168b, and the third connecting plate 168c are respectively connected to the first electrical connecting terminals 161, which are respectively referred to as the first electrical terminal 161a, the second electrical terminal 161b and the third electrical terminal 161c. The first connecting plate 168a, the second connecting plate 168b, and the third connecting plate 168c are respectively connected to the second electrical connecting terminal, which are respectively referred to as the fourth electrical terminal 161a, the fifth electrical terminal 161b and the sixth electrical terminal 161c. The first connecting plate 168a is inclined toward a direction away from the first electrical terminal 161a and the second electrical terminal 161b. The second connecting plate 168b and the third connecting plate 168c are inclined in the same direction as the first connecting plate 168a. The angle between the first connecting plate 168a and the fourth electrical terminal 161a is α1. The angle between the second connecting plate 168b and the fifth electrical terminal 161b is α2. The angle between the third connecting plate 168c and the sixth electrical terminal 161c is α3. α1<α2<α3. This arrangement can ensure a safe distance between the three second electrical connecting terminals 169, reduce the distance between the three first electrical connecting terminals 161, and facilitate the arrangement of the three-phase first lead-out wires 128.

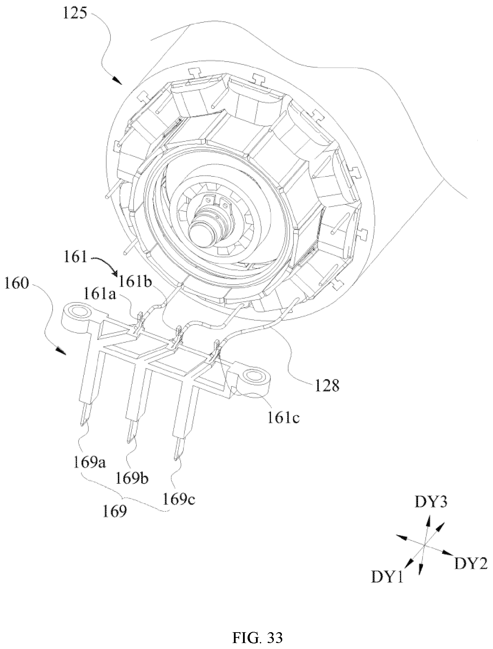

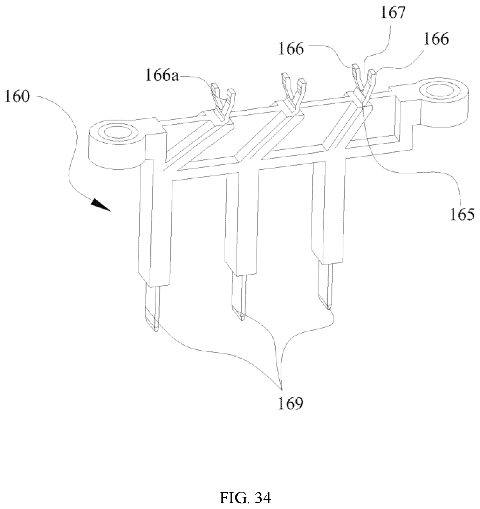

FIG. 33 and FIG. 34 show a further example of the first electrical connecting element 160 or the second electrical connecting element 260. The first electrical connecting element 160 and the second electrical connecting element 260 have the same structure. The first electrical connecting element 160 is described as an example. The first electrical connecting terminal 161 of the first electrical connecting element 160 is divided into two small copper bars and the two small copper bars are combined in a shape of a "Y" structure. The end of the first electrical connecting terminal 161 is formed with a clamping opening for assembling with the first lead-out wire 128. Meanwhile, the two small copper bars both have an arc structure and the center of the arc structure can be arranged concentrically with the end of the first lead-out wire 128. In this way, when the first lead-out wire 128 is assembled to the position of the arc structure, the first lead-out wire 128 can be in good contact with the copper bars. Further, the diameter of the arc structure is slightly smaller than the outer diameter of the conductor of the first lead-out wire 128, so that the contact between the two is firmer. The contact form between the arc structure and the conductor of the first lead-out wire 128 can be the contact between the arc surface and the arc surface. In this way, the contact area is increased, which is conducive to transmitting larger current. Meanwhile, the semi-arc surface has a certain limiting effect on the three-phase wires of the motor.

Referring to FIG. 33 and FIG. 34, the first electrical connecting terminal 161 according to the embodiment can include a base 165 and at least two clamping portions 166 arranged in sequence along the first extension direction DY1. Each clamping portion 166 is connected to the base 165. In a plane perpendicular to the first extension direction DY1, one end of each clamping portion 166 away from the base 165 is spaced apart along the second extension direction DY2 to form a clamping opening 167. One end of the first lead-out wire 128 is electrically connected to the first winding of the first motor 120. The other end of the first lead-out wire 128 extends along the first direction D1 and is clamped into the clamping opening 167. The first lead-out wire 128 is conductively connected to the clamping portion 166. That is, the first electrical connecting terminal 161 is electrically connected to the conductor of the first lead-out wire 128. The second extension direction DY2 intersects the first extension direction DY1. Here, the first extension direction DY1 can be parallel or nearly parallel to the first direction D1. The first extension direction DY1 nearly parallel to the first direction D1 will be understood as that the angle between the first extension direction DY1 and the first direction D1 is in the range of 0° to 15°.

In the installation process, the first lead-out wire 128 can be inserted into the clamping opening 167 along the first extension direction DY1, or the first lead-out wire 128 can be placed into the clamping opening 167 along the third direction D3, or the end of the first lead-out wire 128 can be placed into the clamping opening 167 along other directions or other movement trajectories. Then, if the clamping opening 167 is not sufficient to clamp the first lead-out wire 128, the clamping portion 166 can be bent to fit the first lead-out wire 128 more closely by manual or automatic mechanical means; if the clamping opening 167 can clamp the first lead-out wire 128, the clamping opening 167 can be directly used to clamp the first lead-out wire 128.

For example, in a plane perpendicular to the first extension direction DY1, the ends of the clamping portions 166 close to the base 165 coincide. It will be understood that the extension direction of a part of the clamping portions 166 is arranged to intersect with the extension direction of another part of the clamping portions 166. In a plane perpendicular to the first extension direction DY1, the contour shape of each clamping portion 166 and the base 165 is close to a "Y" shape.

Further, the first electrical connecting terminal 161 extends along the third extension direction DY3. The base 165 is located at the end of the first electrical connecting terminal 161 along the third extension direction DY3. The third extension direction DY3 intersects with the first extension direction DY1 and the second extension direction DY2.

In the illustrated example, the first electrical connecting terminal 161 can include two clamping portions 166. The extension directions of the two clamping portions 166 intersect with each other. The structure of the two clamping portions 166 is simple and convenient to manufacture, which not only saves space but also reduces cost.

Specifically, the first electrical connecting terminal 161 is made of a metal sheet. The manufacturing process can be: cutting one end of the metal sheet into two partial metal sheets arranged side by side along the width direction, the cutting gap extending along the length direction of the metal sheet and only penetrating one end of the metal sheet; and then bending the two separated partial metal sheets in opposite directions along the thickness direction of the metal sheet, thereby manufacturing the first electrical connecting terminal 161. The metal sheet is preferably a copper sheet.

It will be understood that in other examples not shown in the disclosure, the first electrical connecting terminal 161 can include three or more clamping portions 166.

For example, the surface of the clamping portion 166 facing the clamping opening 167 is recessed to form a positioning groove 166a. The positioning groove 166a is configured to accommodate the conductor of the first lead-out wire 128, so as to limit the first lead-out wire 128 from exiting the clamping opening 167.

In the example shown in FIG. 34, the positioning groove 166a is configured to be an arc-shaped groove. This facilitates the adaptation and fitting with the conductor of the first lead-out wire 128, and increases the contact area.

Further, the first electrical connecting terminal 161 can include two clamping portions 166. The gap between the positioning grooves 166a of the two clamping portions 166 along the second extension direction DY2 is less than or equal to the outer diameter of the conductor of the first lead-out wire 128. Thus, when the conductor of the first lead-out wire 128 is arranged in the clamping opening 167, the conductor of the first lead-out wire 128 can be in surface contact with the inner surface of the positioning groove 166a. In particular, when the gap between the positioning grooves 166a of the two clamping portions 166 along the second extension direction DY2 is less than the outer diameter of the conductor of the first lead-out wire 128, the two clamping portions 166 can also apply a clamping force to the conductor of the first lead-out wire 128, thereby making the conductive connection between the first electrical connecting terminal 161 and the conductor of the first lead-out wire 128 more reliable and stable.

Referring to FIGS. 33 and 34 in combination with FIG. 27, in addition, the first electrical connecting element 160 can further include the second electrical connecting terminal 169. The second electrical connecting terminal 169 is adapted to be connected to the motor controller 300. Optionally, the connecting plate 168 is arranged between the second electrical connecting terminal 169 and the first electrical connecting terminal 161. The angle between the connecting plate and the second electrical connecting terminal 169 is greater than 90° and less than 180°. In this way, the distance between the second electrical connecting terminal and the first electrical connecting terminal can be increased.

Referring to FIGS. 33 and 34 in combination with FIG. 27, for example, the three sequentially arranged connecting plates 168 are respectively referred to as the first connecting plate 168a, the second connecting plate 168b and the third connecting plate 168c. The first connecting plate 168a, the second connecting plate 168b, and the third connecting plate 168c are respectively connected to the first electrical connecting terminals 161, which are respectively referred to as the first electrical terminal 161a, the second electrical terminal 161b and the third electrical terminal 161c. The first connecting plate 168a, the second connecting plate 168b, and the third connecting plate 168c are respectively connected to the second electrical connecting terminal, which are respectively referred to as the fourth electrical terminal 161a, the fifth electrical terminal 161b and the sixth electrical terminal 161c. The first connecting plate 168a is inclined toward a direction away from the first electrical terminal 161a and the second electrical terminal 161b. The second connecting plate 168b and the third connecting plate 168c are inclined in the same direction as the first connecting plate 168a. The angle between the first connecting plate 168a and the fourth electrical terminal 161a is α1. The angle between the second connecting plate 168b and the fifth electrical terminal 161b is α2. The angle between the third connecting plate 168c and the sixth electrical terminal 161c is α3. α1<α2<α3. This arrangement can ensure a safe distance between the three second electrical connecting terminals 169, reduce the distance between the three first electrical connecting terminals 161, and facilitate the arrangement of the three-phase first lead-out wires 128.

The structures of the first electrical connecting terminals 161 of the three embodiments can be combined for implementation. Of course, within the scope that can be foreseen by those skilled in the art, the three embodiments can be reasonably modified without requiring creative labor.

Referring to FIGS. 1 to 23, in addition, the motor controller 300 can further include the electric control housing 310, the control circuit board 360, the drive circuit board 370, and the busbar electrical terminal 330. The drive circuit board 370 and the control circuit board 360 are located inside the electric control housing 310. The drive circuit board 370 is closer to the first motor 120 and the second motor 220 than the control circuit board 360. The drive circuit board 370 is electrically connected to the control circuit board 360, the busbar electrical terminal 330, the first lead-out wire 128, and the second lead-out wire 228. The busbar electrical terminal 330 is at least partially exposed outside the electric control housing 310, for being electrically connected to the power supply of the vehicle through an electrical connector and a cable. In a state where the busbar electrical terminal 330 is connected to the power supply of the vehicle, electric energy is supplied to the drive board through the busbar electrical terminal, and the drive circuit board 370 converts the electric energy under the control of the control circuit board 360, and then the electric energy is supplied to the first motor 120 through the first electrical connecting element 160 and the first lead-out wire 128, and to the second motor 220 through the second electrical connecting element 260 and the second lead-out wire 228, thereby controlling the operating states of the first motor 120 and the second motor 220.

Referring to FIGS. 1 to 23, for example, the power device 371 is arranged on the side of the driving circuit board 370 facing the first motor 120 and the second motor 220. The power device 371 arranged corresponding to the first motor 120 can be referred to as the first power device 376. The power devices 371 arranged corresponding to the second motor 220 can be referred to as the second power device 377. The first power device 376 is attached to the first heat dissipator 122 through the heat conduction structure or the heat conduction medium such as heat conduction silicone grease. The second power device 377 is attached to the second heat dissipator 222 through the heat conduction structure or the heat conduction medium such as heat conduction silicone grease. That is, the first power device 376 of the motor controller 300 is arranged corresponding to the first heat dissipator 122 and is attached to the first heat dissipator 122 through heat conduction silicone grease, so as to exchange heat generated by the first power device 376 during operation through the first heat dissipator 122. The second power device 377 of the motor controller 300 is arranged corresponding to the second heat dissipator 222 and is attached to the second heat dissipator 222 through the heat conduction structure or the heat conduction medium such as heat conduction silicone grease, so as to exchange heat generated by the second power device 377 during operation through the second heat dissipator 222. The first power device 376 and the second power device 377 can be silicon carbide MOS, or can be power switching transistors such as IGBT. The first power device 376 and the second power device 377 can each be a power assembly formed by a plurality of power switching transistors.

Referring to FIGS. 1 to 23, in addition, the hydraulic pump of the present disclosure is a bidirectional pump. The hydraulic pump has a first opening and a second opening that are in communication with each other. Hydraulic oil can flow from the first opening to the second opening, or from the second opening to the first opening. The hydraulic energy supply device can further include a detection assembly 140 and an adapter assembly. The detection assembly 140 can include a first sensor 142 and a second sensor 143. The first sensor 142 is adapted to detect the oil temperature at the first opening of the hydraulic pump. The second sensor 143 is adapted to detect the oil temperature at the second opening of the hydraulic pump. One end of the adapter assembly 149 is electrically connected to the first sensor 142 and the second sensor 143. The other end of the adapter assembly 149 is adapted to be electrically connected to the motor controller 300. The first sensor 142 detects the oil temperature at the first opening of the hydraulic pump, and the second sensor 143 detects the oil temperature at the second opening of the hydraulic pump, and both the first sensor 142 and the second sensor 143 are connected to the same adapter assembly 149. In this way, the circuit structure can be simplified, installation and maintenance can be facilitated, and the difficulty and cost of sealing can be reduced.

For example, at least part of the detection assembly 140 is arranged between the hydraulic pump and the motor. The detection assembly 140 here can make full use of the axial space of the hydraulic pump and the motor on the basis of ensuring that the oil temperature of the hydraulic pump can be detected, and the sensing circuit can be shortened.

For example, the adapter assembly 149 can include at least one of a first adapter board 144 and a second adapter board 148. The first adapter board 144 is located inside the motor. The first adapter board 144 is electrically connected to the first sensor 142 and the second sensor 143. The second adapter board 148 is located outside the motor. The second adapter board 148 is adapted to be detachably electrically connected to the motor controller 300.

In one example, the adapter assembly 149 has only the second adapter board 148. The second adapter board 148 can be electrically connected to the motor controller 300 through an electrical connector such as a low-voltage plug. The second adapter board 148 can be electrically connected to the first sensor 142 and the second sensor 143 through the cable, so as to realize communication connection between the detection assembly 140 and the motor controller 300.

In another example, the adapter assembly 149 has only the first adapter board 144. One end of the first adapter board 144 is electrically connected to the first sensor 142 and the second sensor 143, and the other end can be connected to the motor controller 300 through the cable. In this way, communication connection between the detection assembly 140 and the motor controller 300 can also be realized.

In a preferred example, the adapter assembly 149 includes the first adapter board 144, the second adapter board 148, and an adapter post 145. The first adapter board 144 and the second adapter board 148 are both circuit boards. One end of the adapter post 145 is electrically connected to the first adapter board 144. The other end of the adapter post 145 is electrically connected to the second adapter board 148. The adapter post 145 can include an inner conductor and an outer hard shell. The outer hard shell is fixed to the first adapter board 144. One end of the inner conductor is electrically connected to the first adapter board 144. The other end of the inner conductor is electrically connected to the second adapter board 148. The second adapter board 148 can be fixedly connected relative to the motor.

Further, the first sensor 142 is a temperature sensor or a temperature-pressure sensor. The second sensor 143 is a temperature sensor or a temperature-pressure sensor. The first sensor 142 and the second sensor 143 can be the same sensor or different sensors.

For example, the hydraulic pump can include a pump housing. The pump housing can include a first connecting hole and a second connecting hole. The first sensor 142 is mounted in the first connecting hole. The second sensor 143 is mounted in the second connecting hole. By arranging the first connecting hole and the second connecting hole in the pump housing, the detection assembly 140 can be mounted in the pump housing, thereby facilitating improving the accuracy of the detection of the oil temperature at the two openings of the hydraulic pump by the detection assembly 140.

In the hydraulic energy supply device having two motors and two hydraulic pumps, the two motors are the first motor 120 and the second motor 220 coaxially and oppositely arranged. The first motor 120 includes the first housing 121. The second motor 220 includes the second housing 221. The first housing 121 and the second housing 221 are fixedly connected to each other or configured to be an integral piece. The two hydraulic pumps are located at the outer ends of the two motors and coaxially arranged with the motors. The two hydraulic pumps are respectively referred to as the first hydraulic pump 110 and the second hydraulic pump 210. The first hydraulic pump 110 is connected to the first motor 120. The second hydraulic pump 210 is connected to the second motor 220. The pump housing of the first hydraulic pump 110 is the first pump housing. The pump housing of the second hydraulic pump 210 is the second pump housing. The first pump housing is arranged with the first connecting hole 113 and the third connecting hole 114. The first connecting hole 113 is configured to mount the first sensor 142. The third connecting hole 114 is configured to mount the second sensor 143. The second pump housing is arranged with the second connecting hole 114 and the fourth connecting hole 214. The second connecting hole 114 is configured to mount the first sensor 142. The fourth connecting hole 214 is configured to mount the second sensor 143.

Optionally, the first connecting hole is parallel to the second connecting hole. This facilitates machining and assembly of the sensors.

In the illustrated example, the first connecting hole and the second connecting hole are both parallel to the axial direction of the hydraulic pump.

For example, at least one of the first sensor 142 and the second sensor 143 abuts against the first adapter board 144. It will be understood that the first sensor 142 abuts against the first adapter board 144, and the second sensor 143 is connected to the first adapter board 144 in other configurations. Or it will be understood that the first sensor 142 is connected to the first adapter board 144 in other configurations, and the second sensor 143 abuts against the first adapter board 144. Or it will be understood that the first sensor 142 and the second sensor 143 both abut against the first adapter board 144. In this way, the installation operation of the sensor is more simple and convenient, and the assembly efficiency is improved.

Further, an end of at least one of the first sensor 142 and the second sensor 143 is arranged with a spring. The spring abuts against the first adapter board 144. Either one of the first sensor 142 and the second sensor 143 abuts against the first adapter board 144 through the spring, or the first sensor 142 and the second sensor 143 both abut against the first adapter board 144 through the spring. In the installed state, the abutment of the sensor and the first adapter board 144 can be realized by the pre-tightening force of the spring, the reliability of the abutment is improved, and poor contact caused by factors such as bumping and vibration is prevented.

For example, the motor can include the housing. The housing has a temperature sensing through hole. The temperature sensing through hole extends to the outside of the housing at least partially along a direction intersecting the axial direction of the motor. The adapter assembly 149 is mounted in the temperature sensing through hole. By arranging the temperature sensing through hole, at least part of the adapter assembly 149 can be accommodated, the space occupied by the adapter assembly 149 is reduced, and the adapter assembly 149 can be fixed and protected.

In the illustrated example, the temperature sensing through hole passes through the housing along the radial direction of the motor. That is, the temperature sensing through hole extends to the inner cavity of the housing. The first connecting hole and the second connecting hole can be in communication with the inner cavity of the housing along the axial direction of the motor. Thus, the first sensor 142 and the second sensor 143 are conveniently connected to the adapter assembly 149 in the inner cavity of the motor.

Referring to FIGS. 1 to 23, in the hydraulic energy supply device having two motors and two hydraulic pumps, the two motors are the first motor 120 and the second motor 220 coaxially and oppositely arranged. The first motor 120 includes the first housing 121. The second motor 220 includes the second housing 221. The first housing 121 and the second housing 221 are fixedly connected to each other or configured to be an integrated piece. In an embodiment in which the first housing 121 and the second housing 221 are assembled together by welding or the like, the first housing 121 has the first through hole 121e. The second housing 221 has the third through hole 221e. The first through hole 121e and the third through hole 221e are respectively mounted with the adapter assembly 149. In an embodiment in which the first housing 121 and the second housing 221 are configured to be an integrated piece or the integrated housing 500, the integrated housing 500 has the first through hole 500g and the third through hole 500o. The first through hole 500g and the third through hole 500o are respectively mounted with an adapter assembly 149.

In the above embodiments, the flow channel is formed in the inside of the housing. The flow channel and a portion of the housing form the heat dissipator. The heat dissipator is arranged corresponding to the motor controller, so as to cool the power device in the motor controller. The temperature sensing through hole and the flow channel are both located on the same side of the housing and are arranged spaced apart from each other. In the axial direction of the motor, the temperature sensing through hole is located at the end of the housing of the two motors away from each other, i.e. at the outer end of the housing. Because the outer end of the housing is configured to connect the pump housing of the hydraulic pump, this helps to reduce the distance between the adapter assembly and the temperature sensor, and facilitates their installation.

In addition, the housing further includes a motor sensing through hole. The hydraulic energy supply device can further include a motor sensor (not shown). The outgoing end of the motor sensor at least partially passes through the motor sensing through hole. The detection end of the motor sensor is connected to the winding. The motor sensor is connected to the motor controller. The motor sensor is configured to detect the temperature of the winding, so that the vehicle controller can regulate the operating state of the heat dissipator according to the temperature of the winding. For example, when the winding temperature is high, the vehicle control device can control the circulation speed of the cooling circuit of the heat dissipator to be accelerated, thereby improving the heat dissipation efficiency; when the winding temperature is low, the vehicle controller can control the circulation speed of the cooling circuit of the heat dissipator to be slowed down, thereby reducing the energy consumption. In the embodiment in which the first housing and the second housing are assembled together by welding or the like, the first housing has a second through hole 121s. The second housing has a fourth through hole 221s. The second through hole 121s and the fourth through hole 221s are respectively mounted with a motor sensor. In the embodiment in which the first housing and the second housing are configured to be an integrated piece or an integrated housing, the integrated housing 500 has a second through hole 500t and a fourth through hole 500u. The second through hole 500t and the fourth through hole 500u are respectively mounted with a motor sensor.

For example, the motor sensing through hole extends to the outside along the radial direction of the motor. The motor sensing through hole and the temperature sensing through hole are arranged side by side on the same side of the housing. The motor sensing through hole and the flow channel are arranged spaced apart from each other. This facilitates the assembly of the sensor and is conducive to simplifying the circuit and improving space utilization.

The detection assembly 140 according to the present disclosure is arranged on the first motor pump 100 and the second motor pump 200. The detection assembly 140 is configured to detect the oil temperature of the first hydraulic pump 110 and/or the second hydraulic pump 210. The motor controller 300 can further include a signal connector 320. The signal connector 320 is connected to the electric control housing 310. The control circuit board 360 is electrically connected to the signal connector 320 and the detection assembly 140. The signal connector 320 is adapted to be electrically connected to a control device of the vehicle. The detection assembly 140 can detect the oil temperature of the first hydraulic pump 110 and the second hydraulic pump 210 and send the oil temperature to the control circuit board 360. The control circuit board 360 transmits the oil temperature to the control device of the vehicle via the signal connector 320. The control circuit board 360 can also receive a control instruction from the control device and control the operating state of the first motor 120 and the second motor 220 according to the control instruction, thereby indirectly controlling the operating state of the first hydraulic pump 110 and the second hydraulic pump 210.

The detection assembly 140 is arranged between the first motor 120 and the first hydraulic pump 110 and between the second motor 220 and the second hydraulic pump 210. The two detection assemblies 140 can be the same. The application of the detection assembly 140 to the first motor pump 100 will be described below as an example.

Referring to FIGS. 1 to 19, the detection assembly 140 according to the present disclosure is arranged between the first hydraulic pump 110 or the first hydraulic pump 110 and the first motor 120. The detection assembly 140 can include the first sensor 142 and the second sensor 143. The first hydraulic pump 110 is a bidirectional hydraulic pump and includes the first opening and the second opening adapted to circulate oil. The first sensor 142 is configured to detect the oil temperature of the first opening of the first hydraulic pump 110. The second sensor 143 is configured to detect the oil temperature of the second opening of the first hydraulic pump 110. The hydraulic energy supply device can further include the adapter assembly 149. One end of the adapter assembly 149 is electrically connected to the first sensor 142 and the second sensor 143. The other end of the adapter assembly 149 is configured to be electrically connected to the motor controller 300 to send the detected oil temperature to the motor controller 300. The first sensor 142 is connected to the second sensor 143 through the adapter assembly 149, and the adapter assembly 149 can transmit the oil temperature detected by the first sensor 142 and the second sensor 143 to the motor controller 300.

Similarly, the detection assembly 140 is also arranged between the second hydraulic pump 210 or the second hydraulic pump 210 and the second motor 220. The second hydraulic pump 210 is a bidirectional hydraulic pump and includes the first opening and the second opening adapted to circulate oil. The first sensor 142 is configured to detect the oil temperature of the first opening of the second hydraulic pump 210. The second sensor 143 is configured to detect the oil temperature of the second opening of the second hydraulic pump 210. The second motor 220 is arranged with the adapter assembly 149. One end of the adapter assembly 149 is electrically connected to the first sensor 142 and the second sensor 143. The other end of the adapter assembly 149 is configured to be electrically connected to the motor controller 300 to transmit the detected oil temperature to the motor controller 300. The first sensor 142 is connected to the second sensor 143 through the adapter assembly 149, and the adapter assembly 149 can transmit the oil temperatures detected by the first sensor 142 and the second sensor 143 to the motor controller 300.

In this way, the space occupied by the detection assembly 140 can be reduced, the circuit structure is simplified, the sealing difficulty is reduced, the cost is saved, and the compactness of the motor pump structure is improved.

Referring to FIGS. 6 and 16, for example, the first hydraulic pump 110 can include a first pump housing (not labeled). The first pump housing has a first connecting hole 113 and a third connecting hole 114. The first connecting hole 113 and the third connecting hole 114 both extend along the axial direction of the first pump housing to the end surface of the first pump housing facing the first motor 120. The first sensor 142 is mounted in the first connecting hole 113. The second sensor 143 is mounted in the third connecting hole 114. The ends of the first sensor and the second sensor close to the adapter assembly 149 are arranged with a spring (not shown). In this way, the first sensor 142 can be directly mounted in the first connecting hole 113, and the second sensor 143 can be directly mounted in the third connecting hole 114. The first sensor 142 and the second sensor 143 are abutted on the adapter assembly 149 through the spring, and the mounting is convenient. The first housing 121 has the first through hole 121e. The first through hole 121e extends to the inside and outside of the first housing 121 along the direction intersecting the axial direction of the first motor 120. The adapter assembly 149 is arranged through the first through hole 121e. Correspondingly, referring to FIGS. 7 and 17, the second hydraulic pump 210 can include a second pump housing. The second pump housing has the second connecting hole 213 and the fourth connecting hole 214. The second connecting hole 213 and the fourth connecting hole 214 both extend along the axial direction of the second pump housing to the end surface of the second pump housing facing the second motor 220. The first sensor 142 is connected to the second connecting hole 213. The second sensor 143 is connected to the fourth connecting hole 214. The second housing 221 has the third through hole 221e. The third through hole 221e extends to the inside and outside of the second housing 221 along the direction intersecting the axial direction of the second motor 220. The adapter assembly 149 is arranged through the third through hole 221e.

Further, referring to FIGS. 6 and 16, the first connecting hole 113 and the third connecting hole 114 pass through the first pump housing along the axial direction of the first pump housing. The first motor pump 100 can further include two sets of first sealing ring 141. The first sealing rings 141 are respectively sealingly connected between the first sensor 142 and the first connecting hole 113 and between the second sensor 143 and the third connecting hole 114. This facilitates assembly of the first sensor 142 in the first connecting hole 113 and assembly of the second sensor 143 in the third connecting hole 114. The first sealing rings 141 improve the sealing between the first sensor 142 and the first connecting hole 113 and between the second sensor 143 and the third connecting hole 114. Correspondingly, referring to FIGS. 7 and 17, the second connecting hole 213 and the fourth connecting hole 214 pass through the first pump housing along the axial direction of the first pump housing. The second motor pump 200 can further include two sets of second sealing ring 241. The second sealing rings 241 are respectively sealingly connected between the first sensor 142 and the second connecting hole 213 and between the second sensor 143 and the fourth connecting hole 214. This facilitates assembly of the first sensor 142 in the second connecting hole 213 and assembly of the second sensor 143 in the fourth connecting hole 214. The second sealing rings 241 improve the sealing between the first sensor 142 and the second connecting hole 213 and between the second sensor 143 and the fourth connecting hole 214.

Referring to FIGS. 6 to 8, 16 to 18, 23 and 24, for example, the adapter assembly 149 can include the first adapter board 144, the adapter post 145, and the second adapter board 148. The first adapter board 144 is electrically connected to the first sensor 142 and the second sensor 143. Specifically, the first sensor 142 and the second sensor 143 can abut on the first adapter board 144 via the spring. The adapter post 145 is arranged through the first through hole 121e. One end of the adapter post 145 is electrically connected to the first adapter board 144. The second adapter board 148 is electrically connected to the other end of the adapter post 145. The second adapter board 148 is adapted to be detachably electrically connected to the motor controller 300 via an electrical connector such as a low-voltage plug terminal. When the adapter assembly 149 is mounted to the first motor pump 100, the second adapter board 148 is located outside the first motor 120. When the adapter assembly 149 is mounted to the second motor pump 200, the second adapter board 148 is located outside the second motor 220.

Referring to FIGS. 6 to 8 and 16 to 18, the first motor pump 100 can further include a second sealing ring 146 sealingly connected between the adapter assembly 149 and the first through hole 121e. This can improve the sealing between the adapter assembly 149 and the first through hole 121e. Correspondingly, the second motor pump 200 can further include the second sealing ring 146 sealingly connected between the adapter assembly 149 and the third through hole 221e. This can improve the sealing between the adapter assembly 149 and the third through hole 221e.

Referring to FIGS. 6 to 8 and 16 to 18, the first motor pump 100 can further include a first end cover assembly 130. The first end cover assembly 130 is connected to an end of the first hydraulic pump 110 along the axial direction of the first hydraulic pump 110 away from the first motor 120. The first motor 120, the first hydraulic pump 110, and the first end cover assembly 130 form the first motor pump 100. Correspondingly, the second motor pump 200 can further include a second end cover assembly 230. The second end cover assembly 230 is connected to an end of the second hydraulic pump 210 along the axial direction of the second hydraulic pump 210 away from the second motor 220. The second motor 220, the second hydraulic pump 210, and the second end cover assembly 230 form the second motor pump 200.

Referring to FIGS. 1, 8, 10, 11, 18, 19, 20, 24, and 25, the motor controller 300 can further include a vent valve 340. The electric control housing 310 is connected to the first housing 121 and the second housing 221. The vent valve 340 is connected to the electric control housing 310. The vent valve 340 is in communication with the inside and outside of the electric control housing 310 to balance the pressure inside and outside the electric control housing 310. A certain degree of airtightness is generally required between the electric control housing 310 and the first housing 121 and the second housing 221. When the motor controller 300 is in operation, heat is generated in the motor controller 300, which causes the pressure inside the motor controller 300 to change. The vent valve 340 is arranged to balance the pressure inside and outside the electric control housing 310, thereby improving the operation of the motor controller 300.

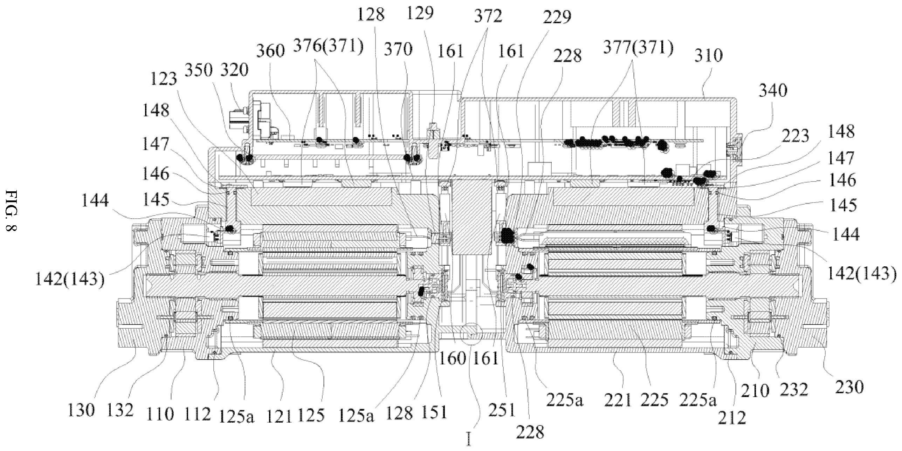

Referring to FIGS. 8, 10, 18, 19, 24, and 25, the motor controller 300 can further include a shielding plate 350. The shielding plate 350 is connected between the control circuit board 360 and the driving circuit board 370 along the first direction D1 to shield interference signals generated by the driving circuit board 370 between the control circuit board 360 and the driving circuit board 370.

As shown in FIG. 1 to FIG. 19, the hydraulic energy supply device of one embodiment of the present disclosure can include the first motor pump 100 and the second motor pump 200 arranged opposite in an axial direction, and a motor controller 300. Here, the axial direction is parallel to the axis of the first motor pump 100 and the axis of the second motor pump 200. The first motor pump 100 includes the first motor 120, the first hydraulic pump 110, and the first end cover assembly 130 arranged in sequence along the axial direction. The first motor 120 is closer to the second motor pump 200. The first end cover assembly 130 is configured to mount to the chassis of the vehicle. The second motor pump 200 includes the second motor 220, the second hydraulic pump 210, and the second end cover assembly 230 arranged in sequence along the axial direction. The second motor 220 is closer to the second motor pump 200. The second end cover assembly 230 is configured to mount to the chassis of the vehicle. The motor controller 300 is connected to the first motor pump 100 and the second motor pump 200. In the mounted state of the hydraulic energy supply device mounted to the vehicle, the motor controller 300 is located above the first motor pump 100 and the second motor pump 200. The motor controller 300 has the signal connector 320, the busbar electrical terminal 330, and the vent valve 340. The signal connector 320 is configured for communication connection to the vehicle. The busbar electrical terminal 330 is configured for motor power supply connection. The breather valve 340 is configured to balance the internal pressure difference of the electric control housing 310.

Referring to FIG. 1 to FIG. 19, the assembly process of the first motor pump 100 can include:
Step one, the first resolver body 153 with the first resolver sealing ring 151 assembled is mounted in the first resolver through hole 121h at the inner end of the first housing 121 through the first resolver circlip 152, wherein, in the mounted state that the first housing 121 is connected to the second housing 221, the inner end of the first housing 121 is closer to the second housing 221 than the outer end of the first housing 121.
Step two, the first electrical connecting element 160 is mounted at the end of the inner end of the first housing 121.
Step three, the adapter post 145 with the second sealing ring 146 and the first adapter board 144 assembled is mounted to the first through hole 121e, after the adapter post 145 is fixed to the first housing 121 through the fixing plate 147, the second adapter board 148 is welded to the signal connecting terminal, such as the signal pin, of the adapter post 145, the second adapter board 148 has a plug-in electrical connector for electrical connection to the control circuit board 360.
Step four, the first motor body 125 is mounted into the first housing 121 from the outer end of the first housing 121, after the first lead-out wire 128 on the first motor body 125 is passed through the first wire passing hole 121g of the first housing 121 and the first insulating sealing element 129 is mounted, the first lead-out wire 128 is connected to the first electrical connecting terminal 161 of the first electrical connecting element 160.
Step five, the temperature sensor with the first sealing ring 141 assembled is mounted to the first connecting hole 113 on the first hydraulic pump 110.
Step six, the first hydraulic pump 110 is sealingly assembled to the end of the outer end of the first housing 121, and the first pump housing limiting hole 121n arranged at the outer end of the first housing 121 and the first pump housing positioning post 111 at the end of the first hydraulic pump 110 cooperate with each other to achieve positioning.
Step seven, the first end cover assembly 130 is sealingly assembled to the end of the first hydraulic pump 110 away from the first housing 121, and the assembly of the first motor pump 100 is completed.

In other words, the installation process of the first motor pump 100 can include: the first resolver body 153 with the first resolver sealing ring 151 is mounted to the end of the first motor pump 100 facing the second motor pump 200, and fixed by the first resolver circlip 152. The first electrical connecting element 160 corresponding to the first motor pump 100 is mounted at the connection between the first motor pump 100 and the second motor pump 200. The first lead-out wire 128 is connected to the first electrical connecting terminal 161 on the first electrical connecting element 160 using an abutting, plugging or snapping means after passing through the first insulating sealing element 129. The second electrical connecting terminal 169 of the first electrical connecting element 160 can be connected to the alternating current terminal 372 on the driving circuit board 370 in a plugging means. The alternating current terminal 372 can be an alternating current connection connector, and is adapted to be plugged with the second electrical connecting terminal 169. That is, the second electrical connecting terminal 169 is plugged into the alternating current connection connector on the driving board and electrically connected. This connection means is similar to the connection between the plug and the socket of a household appliance, and is conducive to production and assembly. After the first motor body 125 is mounted to the end of the first motor pump 100 away from the second motor pump 200 along the axial direction, the first hydraulic pump 110 with the first pump housing sealing ring 112 and the first core sealing ring 125a is mounted at the end of the first housing 121 away from the first motor pump 100 along the axial direction. Finally, the first end cover assembly 130 is mounted at the end of the first hydraulic pump 110 away from the first hydraulic pump 110 along the axial direction. The first end cover assembly 130 here can include the first end cover 131 and the first end cover sealing ring 132. The first end cover 131 can be fastened to the first pump housing of the first hydraulic pump 110 by a fastener such as a bolt. The first end cover sealing ring 132 is arranged between the first hydraulic pump 110 and the first end cover 131. The first end cover 131 has the first cantilever 131a extending towards both sides along the direction intersecting the axis of the first motor pump 100. The first cantilever 131a can be a connecting lug in particular.

The temperature sensor assembled on the first motor pump 100 can be two groups. One group of the two groups of temperature sensors is configured to detect the temperature of the first motor 120, and the other group of temperature sensors is configured to detect the temperature of the first hydraulic pump 110. The temperature signals detected by the two groups of temperature sensors can be sent to the control circuit board 360 through the same adapter post 145 and the second adapter board 148. The sensor configured to detect the temperature of the first motor 120 can also be arranged side by side with the adapter post 145. In this way, space can be saved, sealing cost and signal transfer cost can be reduced. The two groups of temperature sensors can be the same or different.

The first resolver sealing ring 151, the first resolver circlip 152 and the first resolver body 153 constitute part of the first resolver assembly 150.

Referring to FIGS. 1 to 19, the assembling process of the second motor pump 200 can include:
Step one, the second resolver body 253, with the second resolver sealing ring 251 assembled is mounted into the second resolver through hole 221h at the inner end of the second housing 221 through the second resolver circlip 252. In the mounted state that the second housing 221 is connected to the first housing 121, the inner end of the second housing 221 is closer to the first housing 121 than the outer end of the second housing 221.
Step two, the second electrical connecting element 260 is mounted at the end of the inner end of the second housing 221.
Step three, the adapter post 145 with the second sealing ring 146 and the first adapter board 144 assembled is mounted in the third through hole 221e. After the adapter post 145 is fixed to the second housing 221 through the fixing plate 147, the second adapter board 148 is welded to the signal connecting terminal, such as a signal pin, of the transfer post 145. The second adapter board 148 has a plug-in electrical connector for electrical connection to the control circuit board 360.
Step four, the second motor body 225 is mounted into the second housing 221 from the outer end of the second housing 221. After the second lead-out wire 228 on the second motor body 225 is passed through the second wire passing hole 221g of the second housing 221 and the second insulating sealing element 229 is mounted, the second lead-out wire 228 is connected to the second electrical terminal of the second electrical connecting element 260.
Step five, the second temperature sensor with the second first sealing ring 141 assembled is mounted to the second connecting hole 213 on the second hydraulic pump 210.
Step six, the second hydraulic pump 210 is sealingly assembled to the end of the outer end of the second housing 221, and the second pump housing limiting hole 221n arranged at the outer end of the second housing 221 and the second pump housing positioning post 211 at the end of the second hydraulic pump 210 cooperate with each other to achieve positioning.
Step seven, the second end cover assembly 230 is sealingly assembled to the end of the second hydraulic pump 210 away from the second housing 221, and the assembly of the second motor pump 200 is completed.

In other words, the installation process of the second motor pump 200 can include: the second resolver body 253 with the second resolver sealing ring 251 is mounted to the end of the second motor pump 200 facing the first motor pump 100, and fixed by second resolver circlip 252. The second electrical connecting element 260 corresponding to the second motor pump 200 is mounted at the connection between the first motor pump 100 and the second motor pump 200. The second lead 228 is connected to the second electrical terminal on the second electrical connecting element 260 using an abutting, plugging or snapping means after passing through the second insulating sealing member 229. The fifth electrical terminal of the second electrical connecting element 260 can be connected to the alternating current terminal 372 on the drive circuit board 370 using a plugging means. The alternating current terminal 372 can be an alternating current connection connector and is adapted to be plugged with the fifth electrical terminal. That is, the fifth electrical terminal is plugged into the alternating current connection connector on the drive board and is electrically connected. This connection means is similar to the connection between the plug and the socket of the household appliance, and is conducive to production and assembly. After the second motor body 225 is mounted to the end of the second motor pump 200 away from the first motor pump 100 along the axial direction, the second hydraulic pump 210 with the second pump housing sealing ring 212 and the second core sealing ring 225a, is mounted at an end of the second housing 221 away from the second motor pump 200 along the axial direction. Finally, the second end cover assembly 230 is mounted at the end of the second hydraulic pump 210 away from the second hydraulic pump 210 along the axial direction. The second end cover assembly 230 here can include the second end cover 231 and the second end cover sealing ring 232. The second end cover 231 can be fastened to the second pump housing of the second hydraulic pump 210 by a fastener such as a bolt. The second end cover sealing ring 232 is arranged between the second hydraulic pump 210 and the second end cover 231. The second end cover 231 has the second cantilever 231a extending towards both sides along the direction intersecting the axis of the second motor pump 200. The second cantilever 231a can be a connecting lug in particular. The structure of the second cantilever 231a may be the same as, or different from, that of the first cantilever 131a.

The second temperature sensor assembled on the second motor pump 200 can be two groups. One group of the two groups of second temperature sensors is configured to detect the temperature of the second motor 220, and the other group of second temperature sensors is configured to detect the temperature of the second hydraulic pump 210. The temperature signals detected by the two groups of second temperature sensors can be sent to the control circuit board 360 through the same adapter post 145 and the second adapter board 148. The sensor configured to detect the temperature of the first motor 120 can also be arranged side by side with the adapter post 145. In this way, space can be saved and sealing cost and signal transfer costs can be reduced. The two groups of second temperature sensors may be the same or different.

The second resolver sealing ring 251, the second resolver circlip 252, and the second resolver body 253 constitute part of the second resolver assembly 250.

As shown in FIG. 1 to FIG. 19, it is a schematic diagram of the assembly structure of the hydraulic energy supply device of one embodiment of the present disclosure. After the first motor 120 and the second motor 220 are assembled to form the integrated dual-motor, the driving circuit board 370 is mounted on the upper part of the integrated dual-motor and is electrically connected to the first electrical connecting element 160 and the second electrical connecting element 260 respectively. And the power device 371 on the driving circuit board 370 is closely attached to the first heat dissipator 122 and the second heat dissipator 222 by the heat conduction silicone grease. Then, after the control circuit board 360 with the signal connector 320 is mounted in the electric control housing 310, the shielding plate 350 is mounted to shield the area on the control circuit board 360 which is easy to be disturbed to improve the electromagnetic compatibility. After the signal connecting terminal of the second adapter board 148 and the driving circuit board 370 is connected to the control circuit board 360, the electric control housing 310 and the integrated dual-motor are sealed and assembled together. Finally, the busbar electrical terminal 330 is mounted, and the copper bar of the busbar electrical terminal 330 is inserted into the direct current terminal 373 on the driving circuit board 370. Here, the direct current terminal 373 can be a direct current connection connector. The connection mode of the busbar electrical terminal 330 and the direct current connection connector is similar to the connection mode of the plug and the socket of the household electrical appliances, and is simple to assemble and easy to operate, as the connection mode of the first electrical connecting element 160 or the second electrical connecting element 260 and the control circuit board 360 mentioned above. Meanwhile, the three-phase copper bars of the first electrical connecting element 160 and the second electrical connecting element 260 are vertically placed, which is conducive to the heat dissipation of the copper bars. Here, the three-phase copper bars will be understood as the first electrical connecting terminal 161 and the second electrical connecting terminal 169 of the first electrical connecting element 160 and the second electrical connecting element 260.

FIG. 8 is a schematic diagram of the internal structure of the hydraulic energy supply device according to an embodiment of the present disclosure. The figure shows the internal layout of the motor controller 300 and the relationship between the first heat dissipator 122, the second heat dissipator 222 and the power device 371. The first motor 120 and the second motor 220 can have the same structure, and the first heat dissipator 122 and the second heat dissipator 222 can have the same structure. Here, for ease of description, the first motor 120 and the second motor 220 are collectively referred to as a motor, and the first heat dissipator 122 and the second heat dissipator 222 are collectively referred to as a heat dissipator. The heat dissipator can be the heat pipe or the liquid cooling heat dissipation assembly with the heat exchange medium. The power device 371 is arranged above the heat dissipator of each motor. The power device 371 can be an IGBT power device, a silicon carbide MOS tube or the like. The heat dissipator is deeply buried in the motor housing, and the inside of the housing also has circulating oil. In this way, the power device 371 can be well cooled by the heat dissipator, so that the temperature condition of the power device 371 during use is more favorable. The drive circuit board 370, the shielding plate 350, the control circuit board 360 and the electric control housing 310 are arranged on the power device 371. The signal connector 320 of the control circuit board 360 passes through the electric control housing 310 and extends to the outside. The electric control housing 310 is also mounted with the vent valve 340 for preventing condensation and balancing the pressure difference of heat dissipation. The second adapter board 148 and the fixing plate 147 are provided below the two ends of the control circuit board 360 along the second direction D2. The adapter post 145 assembled with the second sealing ring 146 and the first adapter board 144 is mounted into the temperature sensing through hole 121e, 221e. The other end of the adapter post 145 is assembled with the first adapter board 144. The first adapter board 144 is connected to and in electrical connection with the first sensor 142 and the second sensor 143 through the springs of the first sensor 142 and the second sensor 143. Each motor pump is arranged with two sensors for detecting temperature. One sensor is the first sensor 142 and the second sensor 143. The first sensor 142 and the second sensor 143 are sensors for detecting the oil temperature of the inlet and outlet of the hydraulic pump. The other sensor can be referred to as the motor sensor, which can be the motor NTC temperature sensor, for detecting the temperature of the winding of the motor. The temperature signals detected by the first sensor 142 and the second sensor 143 are transmitted to the second adapter board 148 through the first adapter board 144 and the adapter post 145, and then transmitted to the control circuit board 360 through the second adapter post 148, thereby saving space and reducing sealing and signal switching costs.

Referring to FIGS. 1 to 19, the hydraulic energy supply device according to the present disclosure, by friction welding two motors, the first housing 121 and the second housing 221 are more firmly joined. Alternatively, the housings of the two motors are integrally formed, which is not only firmer, but also can improve the sealing performance and assembly efficiency. By adding the first heat dissipator 122 to the first housing 121 and adding the second heat dissipator 222 to the second housing 221, the heat dissipation effect of the power device 371 of the motor controller 300 can be improved, thereby improving the power of the motor under the same volume. Meanwhile, the first electrical connecting element 160 and the second electrical connecting element 260 of the three embodiments are provided, which can well solve well the connection between the lead-out wires of the motor winding and the motor controller 300. The detection assembly 140 is arranged to detect temperature data, wherein the first sensor 142 and the second sensor 143 are configured to detect the oil temperature at the inlet and outlet of the hydraulic pump, and the motor NTC temperature sensor is configured to detect the temperature of the motor winding. After the detection assembly 140 is combined and assembled with the adapter assembly 149 including the first adapter board 144, the adapter post 145, the second sealing ring 146, the fixing plate 147, and the second adapter board 148, the connector that is convenient for plug-in installation can be formed. Moreover, the first adapter assembly 149 of the first motor pump 100 and the second adapter assembly 149 of the second motor pump 200 are both connected to the control circuit board 360, which can save the lines. The connection between the direct current busbar electrical terminal 330 and the driving circuit board 370 and the connection between the first electrical connecting element 160, the second electrical connecting element 260 and the driving circuit board 370 are both in the connector connection mode, which can save assembly space and is conducive to automatic production, and meanwhile, the connection copper bars of the first electrical connecting element 160 and the second electrical connecting element 260 are all placed in a three-dimensional configuration, which can improve the heat dissipation effect.

The present disclosure also provides a chassis system. The chassis system can include a shock absorber and the hydraulic energy supply device according to the above. The hydraulic energy supply device is in fluid communication with the shock absorber. The hydraulic energy supply device is configured to achieve active damping control of the shock absorber.

According to the chassis system provided by the present disclosure, by applying the hydraulic energy supply device, the damping effect of the chassis system can be improved.

The present disclosure also provides a vehicle. The vehicle can include the hydraulic energy supply device according to the above, or can include the chassis system according to the above.

According to the vehicle provided by the present disclosure, by applying the hydraulic energy supply device or the chassis system, the stability of the vehicle during driving and the comfort of the driver and passengers can be improved.

Referring to FIGS. 1 to 25, for example, the vehicle can also include an air conditioner. The air conditioner is in fluid communication with the first flow channel 121o, 500i and the second flow channel 221o, 500q to share the heat exchange medium with the first flow channel 121o, 500i and the second flow channel 221o, 500q. By fluidly communicating the hydraulic energy supply device with the air conditioner and sharing the heat exchange medium, the structure can be simplified and the cost can be reduced.

In one example, the second opening 121q is in fluid communication with the third opening 221p. The air conditioner is connected in series between the first opening 121p and the fourth opening 221q by a pipe. That is, the first flow channel 121o, 500i, the second flow channel 221o, 500q, and the air conditioner are connected in series.

In another example, the air conditioner is connected in series between the first opening 121p and the second opening 121q by a pipe. Also, the air conditioner is connected in series between the third opening 221p and the fourth opening 221q by a pipe. That is, the first flow channel 121o, 500i and the second flow channel 221o, 500q are connected in parallel to the air conditioner.

Unless otherwise defined, technical and scientific terms used herein have the same meaning as commonly understood by one of ordinary skill in the art. The terminology used herein is for the purpose of describing specific implementations only, and is not intended to limit the disclosure. Terms such as "arrange" as appeared herein may mean either that one component is directly attached to another component or that one component is attached to another component through an intermediate piece. Features described herein in one embodiment may be applied to another embodiment, alone or in combination with other features, unless the feature is not applicable in the other embodiment or otherwise stated.

The present disclosure has been described through the above-described embodiments, but it will be understood that the above-described embodiments are for the purpose of example and illustration, and are not intended to limit the present disclosure to the described embodiments. It can be understood by those skilled in the art that more various modifications and changes can be made according to the teachings of the present disclosure, and all of the modifications and changes fall within the scope of the present disclosure claimed.

## Claims

1. A motor assembly (700), comprising:
a first motor body (125);
a second motor body (225), the second motor body (225) and the first motor body (125) being arranged opposite to each other along an axial direction (D) of the first motor body (125); and
a common housing, the second motor body (225) and the first motor body (125) being jointly arranged in the common housing.

2. The motor assembly (700) according to claim 1, comprising:
a first housing (121) and a second housing (221), the first motor body (125) being arranged in the first housing (121), the second motor body (225) being arranged in the second housing (221), and the second housing (221) and the first housing (121) being an integral piece to form the common housing.

3. The motor assembly (700) according to claim 1 or 2, comprising:
the first housing (121) and the second housing (221), an inside of the first housing (121) accommodating the first motor body (125), an inside of the second housing (221) accommodating the second motor body (225), and the second housing (221) being welded to the first housing (121) to form the common housing.

4. The motor assembly (700) according to claim 3, wherein
an end of the first housing (121) close to the second housing (221) is formed with a recess (121j);
an end of the second housing (221) close to the first housing (121) is formed with a boss (221j), the boss (221j) is adapted to the recess (121j), and the boss (221j) is welded and fixed to the recess (121j) to fix the second housing (221) to the first housing (121).

5. The motor assembly (700) according to any one of claims 1 to 4, further comprising:
a motor controller (300) connected to the common housing, a portion of the common housing facing the motor controller (300) being formed with a first flow channel (121o) and a second flow channel (221o),
wherein the first flow channel (121o) and the first motor body (125) are correspondingly arranged;
the second flow channel (221o) and the second motor body (225) are correspondingly arranged.

6. The motor assembly (700) according to claim 5, wherein
the common housing comprises:
a housing body (121a, 221a), a first mounting groove (121b) and a second mounting groove (221b) being arranged at a portion of the housing body (121a, 221a) facing the motor controller (300);
a first flow channel plate (124) connected to the first mounting groove (121b) to form a first heat dissipation cavity (121t) with the housing body (121a, 221a), the first flow channel plate (124) supporting the motor controller (300);
a first flow guide rib (121c) connected to the first heat dissipation cavity (121t) to define the first heat dissipation cavity (121t) as the first flow channel (121o);
a second flow channel plate (224) connected to the second mounting groove (221b) to form a second heat dissipation cavity (221t) with the housing body (121a, 221a), the second flow channel plate (224) supporting the motor controller (300); and
a second flow guide rib (221c) connected to the second heat dissipation cavity (221t) to define the second heat dissipation cavity (221t) as the second flow channel (221o).

7. The motor assembly (700) according to claim 6, wherein
the first flow channel plate (124) comprises a first auxiliary heat dissipation body (124a) extending to the first flow channel (121o); and/or
the second flow channel plate (224) comprises a second auxiliary heat dissipation body (224a) extending to the second flow channel (221o).

8. The motor assembly (700) according to claim 7, wherein
the first auxiliary heat dissipation body (124a) is configured to be a first heat dissipation pin, the first flow channel plate (124) comprises a plurality of the first heat dissipation pins, and each of the first heat dissipation pins is spaced apart along an arrangement path adapted to the first flow channel (121o); and/or
the second auxiliary heat dissipation body (224a) is configured to be a second heat dissipation pin, the second flow channel plate (224) comprises a plurality of the second heat dissipation pins, and each of the second heat dissipation pins is spaced apart along an arrangement path adapted to the second flow channel (221o).

9. The motor assembly (700) according to any one of claims 6 to 8, wherein
the first flow guide rib (121c) and the housing body (121a, 221a) are integrally formed; and/or
the second flow guide rib (221c) and the housing body (121a, 221a) are integrally formed.

10. The motor assembly (700) according to any one of claims 5 to 9, wherein
the portion of the common housing facing the motor controller (300) is arranged with an accommodation groove (400), the accommodation groove (400) is located between the first motor body (125) and the second motor body (225);
the accommodation groove is configured to at least accommodate a capacitor of the motor controller (300).

11. The motor assembly (700) according to claim 10, wherein
the first flow channel (121o) and the second flow channel (221o) are spaced apart by the accommodation groove (400), and the first flow channel (121o) and the second flow channel (221o) are in communication with each other.

12. The motor assembly (700) according to claim 11, wherein the common housing comprises the housing body (121a, 221a) and a flow-through cover plate (501), a side wall of the housing body (121a, 221a) is arranged with a flow-through groove (500c), and the flow-through cover plate (501) is sealingly connected to an opening of the flow-through groove (500c) to form a flow-through channel with the housing body (121a, 221a), and the first flow channel (121o) and the second flow channel (221o) are in communication through the flow-through channel.

13. The motor assembly (700) according to claim 11 or 12, wherein
the first flow channel (121o) has a first opening (121p) and a second opening (121q), the first opening (121p) is in communication with the outside of the common housing, the second flow channel (221o) has a third opening (221p) and a fourth opening (221q), the fourth opening (221q) is in communication with the outside of the common housing, and the second opening (121q) is in communication with the third opening (221p).

14. The motor assembly (700) according to any one of claims 10 to 13, wherein the motor controller (300) further comprises a capacitor (375), a first power device (376) and a second power device (377), the first power device (376) corresponds to the first motor body (125), the second power device (377) corresponds to the second motor body (225), and the capacitor (375) is connected to the first power device (376) and the second power device (377) respectively.

15. The motor assembly (700) according to any one of claims 5 to 14, wherein
the motor controller (300) comprises an electric control housing (310) and a vent valve (340), the electric control housing (310) is connected to the common housing, the vent valve (340) is connected to the electric control housing (310), and the vent valve (340) is in communication with the inside and outside of the electric control housing (310).

16. A hydraulic energy supply device (600) for an active suspension, comprising:
a motor assembly (700) according to any one of claims 1 to 15;
a first hydraulic pump (110) connected to a first motor (120) to be driven by the first motor (120); and
a second hydraulic pump (210) connected to a second motor (220) to be driven by the second motor (220).

17. A chassis system, comprising:
a shock absorber; and
the hydraulic energy supply device (600) according to claim 16, the hydraulic energy supply device (600) being in fluid communication with the shock absorber.

18. A vehicle, comprising the motor assembly (700) according to any one of claims 1 to 15, or the hydraulic energy supply device (600) according to claim 16, or the chassis system according to claim 17.

19. The vehicle according to claim 18, wherein,
the motor assembly (700) comprises:
the first flow channel (121o), the first flow channel (121o) and the first motor (120) being correspondingly arranged, the first flow channel (121o) being configured to circulate a heat exchange medium to cool the first motor (120) and the motor controller (300); and
the second flow channel (221o), the second flow channel (221o) and the second motor (220) being correspondingly arranged, the second flow channel (221o) being configured to circulate the heat exchange medium to cool the second motor (220) and the motor controller (300),
the vehicle further comprising an air conditioner in fluid communication with the first flow channel (121o) and/or the second flow channel (221o) to share the heat exchange medium with the first flow channel (121o) and/or the second flow channel (221o).
